# EUROPEAN PATENT APPLICATION

(11) **EP 4 510 183 A1**
(43) Date of publication of application: **19.02.2025**
(21) Application number: 22942813.1
(22) Date of filing: 20.05.2022
(51) Int. Cl.: H01L 23/473, H01L 23/367

(54) **DOUBLE-SIDE-COOLING POWER SEMICONDUCTOR PACKAGE**

(71) Applicant: LG Magna e-Powertrain Co., Ltd., Seo-gu, Incheon 22744 (KR)
(72) Inventor: KANG, Myeongyu, Incheon 22744 (KR); PAEK, Hyunwoo, Incheon 22744 (KR); KIM, Yongsik, Incheon 22744 (KR); KIM, Jonghoon, Incheon 22744 (KR)
(74) Representative: Vossius & Partner Patentanwälte Rechtsanwälte mbB
(86) International application number: PCT/KR2022/007249
(87) International publication number: WO 2023/224149

(57) **Abstract**

The present invention relates to a double-side-cooling power semiconductor package and comprises: a planar power semiconductor package; heatsinks which are respectively disposed on both sides of the power semiconductor package along the thickness direction thereof; and a plurality of cooling channels which have therein a flow path for a cooling fluid, and are respectively disposed on both sides of the power semiconductor package along the thickness direction thereof, wherein the plurality of cooling channels have respective penetrated portions which are penetrated to allow one areas of the heatsinks to be inserted therein. Accordingly, cooling performance can be increased to correspond to the amount of heat generation in the power semiconductor package.

## Description

### Technical Field

The present disclosure relates to a double-side cooling power semiconductor package.

### Background Art

As is generally known, semiconductor elements are electronic circuit elements made of semiconductors.

Among those semiconductor elements, an electric power module, a power module or a power semiconductor package (hereinafter, referred to as a "power semiconductor package") implemented as a package including an IGBT and a diode is used for power control of a power device.

The power semiconductor package is typically used in industrial applications such as inverters, uninterruptible power supplies, welders, elevators, and automotive fields.

However, in such a conventional power semiconductor package, a large amount of heat loss occurs during a power conversion process, and the occurrence of heat loss not only causes a temperature rise in the power semiconductor package, but also, if the temperature of the power semiconductor package increases and exceeds an operating temperature limit of the power semiconductor package, there is a problem in that the function of the power semiconductor package may be damaged.

In consideration of those problems, there is disclosed a cooling device of a power semiconductor package capable of cooling the power semiconductor package by allowing a cooling channel to be disposed in contact with both sides of the power semiconductor package.

However, in such a conventional cooling device of the power semiconductor package, the cooling channel is disposed to have a long length so as to sequentially pass through upper and lower surfaces of the power semiconductor package, so there is a problem in that a flow resistance of the cooling fluid (coolant) increases.

Furthermore, a temperature deviation between the cooling fluid in the cooling channel on an upper surface of the power semiconductor package and the cooling fluid in the cooling channel on a lower surface of the power semiconductor package increases, so there is a problem in that forced deterioration is accelerated because cooling in regions with relatively high temperatures is insufficient.

In addition, there is a problem that power semiconductor packages that come into contact with a downstream region of the cooling channel, in which the temperature of the cooling fluid is relatively high, are relatively poorly cooled compared to those that come into contact with an upstream region of the cooling channel, in which the temperature of the cooling fluid is relatively low.

In consideration of those problems, some have designed a double-side cooling device of a power semiconductor package having a direct cooling passage that allows cooling fluid to be in direct contact with upper and lower surfaces of the power semiconductor package.

However, in the case of a double-side cooling device of a power semiconductor package having such a conventional direct cooling passage, upper and lower surfaces of the power semiconductor package are in direct contact with cooling fluid, and thus heat dissipation of the power semiconductor package is limited to a surface area of the power semiconductor package, thereby having a problem in that there is a limit to lowering the temperature of the power semiconductor package.

Furthermore, the entire power semiconductor package is configured to be immersed in cooling fluid, and thus the power semiconductor package is provided with a waterproof structure for protecting circuit elements (chips), which are actual sources of heat generation, from the cooling fluid, and the circuit elements are sealed through the waterproof structure, thereby having a problem in that heat dissipation of the circuit elements becomes difficult.

In addition, there is a problem in that there is a limit to lowering the temperature of the circuit elements (chips) that are the sources of heat generation.

### [Citation List]

### [Patent Literature]

(Patent Literature 1) KR1020170056196 (published on May 23, 2017)
(Patent Literature 2) KR1020170042067 (published on April 18, 2017)

### Disclosure of Invention

### Technical Problem

Accordingly, an aspect of the present disclosure is to provide a double-side cooling power semiconductor package capable of improving cooling performance to correspond to an amount of heat generation of the power semiconductor package.

Furthermore, another aspect of the present disclosure is to provide a double-side cooling power semiconductor package capable of accelerating heat dissipation while suppressing direct contact between the power semiconductor package and cooling fluid.

In addition, still another aspect of the present disclosure is to provide a double-side cooling power semiconductor package capable of lowering an actual temperature during an operation of the power semiconductor package so as to suppress the occurrence of an error due to high temperatures.

### Solution to Problem

In order to solve the foregoing problems, in a double-side cooling power semiconductor package according to the present disclosure, heat sinks may be provided on both sides of the power semiconductor package so as to allow cooling fluid and the heat sinks to be in direct contact with each other.

Specifically, heat sinks may be respectively provided on both sides of the power semiconductor package, and the heat sinks may be inserted into a cooling channel to come into direct contact with cooling fluid, thereby increasing a heat dissipation area of the heat sinks to correspond to an amount of heat generation of the power semiconductor package.

Furthermore, the cooling performance of the power semiconductor package may be improved by suppressing direct contact between the power semiconductor package and the cooling fluid.

In addition, the heat dissipation performance of the power semiconductor package may be improved so as to reduce an actual temperature of the circuit elements (chips) of the power semiconductor package.

A double-side cooling power semiconductor package according to one embodiment of the present disclosure may include a plate-shaped power semiconductor package; heat sinks disposed along a thickness direction of the power semiconductor package on both sides thereof; and a plurality of cooling channels provided with a passage of cooling fluid thereinside, and provided along the thickness direction of the power semiconductor package on both sides thereof, wherein through portions to allow one region of the heat sink to be inserted thereinto are respectively provided in the plurality of cooling channels.

Accordingly, a heat dissipation area of the heat sink may be increased to correspond to an amount of heat generation of the power semiconductor package, thereby improving the cooling performance of the power semiconductor package.

Furthermore, direct contact between the power semiconductor package and the cooling fluid may be suppressed, thereby suppressing the formation of a waterproof structure of the power semiconductor package or minimizing a thickness of the waterproof structure.

Through this, heat dissipation of a plurality of circuit elements (chips), which are heat sources inside the power semiconductor package, may be easily achieved.

In addition, heat energy generated in the power semiconductor package may be quickly and easily transferred to the heat sink, thereby maintaining an actual temperature of the power semiconductor package at a relatively low state during operation.

With this configuration, the occurrence of an error caused by high temperatures due to an excessive temperature rise of the power semiconductor package may be suppressed.

In one embodiment of the present disclosure, the plurality of cooling channels may each include a body one side of which is in contact with the power semiconductor package along a thickness direction; and a cover coupled to the other side of the body to form the passage of cooling fluid with respect to the body, wherein the through portion is disposed to pass through the body along the thickness direction.

Through this, the manufacture of the plurality of cooling channels may be easily carried out.

In one embodiment of the present disclosure, a body sealant corresponding to a rim shape of the body may be provided in a mutual contact region between the body and the cover.

Through this, the leakage of the cooling fluid through a gap in a mutual contact region between the body and the cover may be suppressed.

In one embodiment of the present disclosure, a body sealant receiving portion may be disposed in the body so as to receive the body sealant.

Here, the body sealant is formed of an elastic member.

The body sealant receiving portion is configured to receive a portion of the body sealant, and another portion of the body sealant protrudes outside the body sealant receiving portion to be elastically in contact with the cover.

In one embodiment of the present disclosure, the cooling channel may include a lower channel provided on a lower side of the power semiconductor package; and an upper channel provided on an upper side of the power semiconductor package.

Through this, lower and upper surfaces of the power semiconductor package may be cooled simultaneously.

In one embodiment of the present disclosure, the lower channel and the upper channel may be connected in parallel to a cooling fluid circulation circuit in which the cooling fluid is circulated.

Through this, the cooling fluid of the cooling fluid circulation circuit may be branched to move to the lower channel and the upper channel, respectively, thereby suppressing a temperature deviation between the lower surface and the upper surface of the power semiconductor package from occurring.

In one embodiment of the present disclosure, the lower channel may include an inlet port through which the cooling fluid flows in; and an outlet port through which the cooling fluid flows out, wherein the inlet port and the outlet port are each connected to the cooling fluid circulation circuit.

Through this, the cooling fluid, whose temperature has increased through the lower channel and the upper channel, moves to the cooling fluid circulation circuit through the outlet port, and the cooling fluid, whose temperature has decreased through the cooling fluid circulation circuit, moves to the lower channel and the upper channel by way of the inlet port.

In one embodiment of the present disclosure, the body may be provided with an extension portion that is recessed in a thickness direction so as to have a size that is extended compared to that of the through portion around the through portion,

wherein an extension portion sealant that comes into contact with the heat sink so as to suppress the leakage of the cooling fluid is provided inside the extension portion.

Through this, the cooling fluid of the cooling channel may be prevented from leaking through the through portion.

In one embodiment of the present disclosure, the heat sink may include a plate that comes into contact with the power semiconductor package with a size that is extended compared to that of the extension portion; and a plurality of heat dissipation fins protruding in a thickness direction from the plate.

Through this, the occurrence of a surface temperature deviation of the power semiconductor package may be suppressed.

Specifically, when the surface temperature deviation of the power semiconductor package occurs excessively, forced deterioration may be accelerated due to high temperatures in a region of an extension portion sealant disposed in a section where a surface temperature of the power semiconductor package excessively rises over an entire section of the extension portion sealant.

In this embodiment, the heat sink may be provided with a plate having a larger size than the extension portion, and the plate may relatively reduce the surface temperature deviation by the conductor so as to allow the extension portion sealant to come into contact with the plate having a relatively uniform surface temperature, thereby suppressing forced deterioration due to an excessive temperature deviation of the surface from occurring.

In one embodiment of the present disclosure, the heat sink may include a waveform heat dissipation fin having a waveform cross-section, wherein the waveform heat dissipation fin is coupled to a surface (upper substrate, lower substrate) of the power semiconductor package.

Through this, the waveform heat dissipation fin may be directly coupled to upper and lower substrates of the power semiconductor package, without being provided with a plate-shaped plate coupled to a surface (upper substrate, lower substrate) of the power semiconductor package, thereby suppressing an increase in thermal resistance due to the use of the plate.

Through this, the heat dissipation and cooling of the power semiconductor package may be accelerated.

In one embodiment of the present disclosure, the inlet and outlet ports may be respectively disposed in the cover, wherein a body of the lower channel and a body of the upper channel are each provided with an inlet passage communicating with the inlet port and an outlet passage communicating with the outlet port.

Through this, cooling fluid flowing into the inlet port moves to a passage of the lower channel and a passage of the upper channel, respectively, through the inlet passage, and joins in the outlet passage and moves to the outlet port.

In one embodiment of the present disclosure, inlet-side and outlet-side end portions of the lower channel and the upper channel may be each provided with protruding portions that protrude along a thickness direction to come into contact with each other, wherein a power semiconductor package insertion space is formed into which the power semiconductor package is inserted between the protruding portions, and the inlet and outlet passages are respectively disposed inside the protruding portions.

Through this, the cooling of the lower and upper surfaces of the power semiconductor package, and both side surfaces along a plate surface direction of the power semiconductor package may be accelerated.

In one embodiment of the present disclosure, a protruding portion sealant may be provided in a mutual contact region between the protruding portions to suppress the leakage of the cooling fluid.

Through this, the cooling fluid may be prevented from leaking through a gap in the mutual contact region between the protruding portions.

In one embodiment of the present disclosure, the power semiconductor package may be configured with a plurality of units spaced apart from one another along a plate surface direction, wherein the body is provided with a plurality of through portions spaced apart from one another along a plate surface direction to allow the heat sinks of the plurality of power semiconductor packages to be inserted thereinto, respectively.

Through this, the manufacture of the plurality of cooling channels may be easily carried out.

In one embodiment of the present disclosure, the power semiconductor package may be configured with a plurality of units spaced apart from one another along a thickness direction, wherein the cooling channel includes a lower channel disposed at a lowermost side of the power semiconductor package configured with the plurality of units; an upper channel disposed at an uppermost side of the power semiconductor package configured with the plurality of units; and an intermediate channel disposed between the power semiconductor packages configured with the plurality of units, and the lower channel, the upper channel, and the intermediate channel are each disposed such that inlet and outlet sides of the cooling fluid are connected in communication with one another.

Through this, a plurality of power semiconductor packages spaced apart from one another along a thickness direction may be cooled simultaneously.

Furthermore, the occurrence of a temperature deviation between the lower and upper surfaces of each of the power semiconductor packages may be suppressed.

In one embodiment of the present disclosure, the lower channel may include a lower body disposed at a lowermost side of the power semiconductor package configured with the plurality of units and disposed to have the through portion; and a lower cover coupled to a bottom portion of the lower body to form the passage of cooling fluid thereinside, the upper channel may include an upper body disposed at an uppermost side of the power semiconductor package configured with the plurality of units and disposed to have the through portion; and an upper cover coupled to an upper surface of the upper body to form the passage of cooling fluid thereinside, and the intermediate channel may include an upper body disposed on an upper side of the power semiconductor package configured with the plurality of units and provided with the through portion; a lower body disposed to be spaced apart from an upper side of the upper body, coupled to a lower surface of the power semiconductor package configured with the plurality of units, and provided with the through portion; and an intermediate cover disposed between the upper body and the lower body to partition an inside of the upper body and an inside of the lower body.

Through this, the manufacture of the lower channel, upper channel, and intermediate channel may be easily carried out.

In one embodiment of the present disclosure, the lower cover may be provided with an inlet port through which the cooling fluid flows in and an outlet port through which the cooling fluid flows out, and the lower body and the upper body may be provided with an inlet passage communicating with the inlet port and an outlet passage communicating with the outlet port.

Through this, the lower channel, the intermediate channel, and the upper channel may be connected in communication with one another.

In one embodiment of the present disclosure, the power semiconductor package may be configured with a plurality of units spaced apart from one another along a plate surface direction, wherein the power semiconductor package configured with the plurality of units is each provided with the lower channel and the upper channel, and the lower channel and the upper channel spaced apart from each other along the plate surface direction are respectively connected in communication with each other by a connector disposed along the plate surface direction.

Through this, the cooling fluid may cool each of the plurality of power semiconductor packages while moving along a plate surface direction.

In one embodiment of the present disclosure, the upper channel and lower channel of the power semiconductor package configured with the plurality of units may be each provided with a connector coupling portion to which the connector is coupled, wherein a connector sealant is provided in a mutual contact region between the each connector coupling portion and the each connector.

Through this, when thermal deformation occurs along a plate surface direction of the power semiconductor package, the thermal deformation may be absorbed by the slip of the connector, the connector coupling portion, and the connector sealant.

### Advantageous Effects of Invention

As described above, according to one embodiment of the present disclosure, heat sinks disposed on both sides of a power semiconductor package, respectively, and a plurality of cooling channels provided with a passage of cooling fluid thereinside, provided on both sides of the power semiconductor package, respectively, but provided with a through portion to receive one region of the heat sinks may be provided, thereby increasing a heat dissipation region of the heat sinks corresponding to an amount of heat generation of the power semiconductor package, and improving the cooling performance of the power semiconductor package.

Furthermore, the power semiconductor package may be suppressed from coming into direct contact with the cooling fluid.

In addition, the plurality of cooling channels may be each provided with a body and a cover that is coupled to the body to form the passage of cooling fluid, thereby easily carrying out the manufacture of the plurality of cooling channels.

Moreover, a body sealant may be provided in a mutual contact region between the body and the cover, thereby suppressing cooling fluid from leaking between the body and the cover.

Besides, the plurality of cooling channels may be provided with a lower channel provided on a lower side of the power semiconductor package and an upper channel provided on an upper side thereof, thereby cooling lower and upper surfaces of the power semiconductor package simultaneously.

Furthermore, the lower channel and the upper channel may be connected in parallel to a cooling fluid circulation circuit so as to allow cooling fluid to be branched to move to the lower channel and the upper channel, respectively, thereby suppressing a temperature deviation between the lower and upper surfaces of the power semiconductor package from occurring.

In addition, the body may be provided with an extension portion having a size that is extended compared to a circumference of the through portion, and the extension portion may be provided with an extension portion sealant that comes into contact with the heat sink to suppress the leakage of the cooling fluid, thereby suppressing the cooling fluid from leaking to the outside through the through portion.

Moreover, the heat sink may be provided with a plate larger than the extension portion and a plurality of heat dissipation fins protruding in a thickness direction from the plate so as to allow the extension portion sealant to come into contact with the plate where a relatively small surface temperature deviation occurs, thereby suppressing forced deterioration due to a temperature rise of the extension portion sealant from occurring.

Besides, the heat sink may come into direct contact with a surface of the power semiconductor package with a waveform cross-section, thereby eliminating the use of a plate and suppressing an increase in thermal resistance caused by the plate. Through this, heat dissipation and cooling of the power semiconductor package may be accelerated.

Furthermore, inlet-side and outlet-side end portions of the lower channel and the upper channel may be respectively provided with protruding portions that protrude along a thickness direction and come into contact with each other, a power semiconductor package insertion space into which the power semiconductor package is inserted may be provided between the protruding portions, and an inlet passage and an outlet passage may be disposed inside the protruding portions, thereby cooling lower and upper surfaces of the power semiconductor package, and both side surfaces along a plate surface direction of the power semiconductor package, respectively.

In addition, a protruding portion sealant may be provided in a mutual contact region between the protruding portions, thereby suppressing the cooling fluid from leaking through a gap in the mutual contact region between the protruding portions.

Moreover, the power semiconductor package may be provided with a plurality of units spaced apart along a plate surface direction, and the body may be provided with a plurality of through portions to allow heat sinks of the plurality of power semiconductor packages to be respectively inserted thereinto, thereby easily carrying out the manufacture of the plurality of cooling channels.

Besides, the power semiconductor package may be configured with a plurality of units spaced apart from one another along a thickness direction, the cooling channel may be provided with a lower channel provided on a lower side of the power semiconductor package, an upper channel provided on a upper side thereof, and an intermediate channel provided in the middle thereof, and inlet and outlet sides of the lower channel, the upper channel, and the intermediate channel may be disposed in communication with each other, thereby cooling the plurality of power semiconductor packages simultaneously.

Furthermore, the occurrences of a temperature deviation between the lower and upper surfaces of the plurality of the power semiconductor packages may be respectively suppressed.

In addition, the power semiconductor package may be configured with a plurality of units spaced apart from one another along a plate surface direction, the power semiconductor package configured with the plurality of units may be provided with the lower channels and the upper channels, respectively, and the lower channels and the upper channels spaced apart from each other along the plate surface direction may be respectively connected in communication with each other by connectors disposed along the plate surface direction, thereby cooling the plurality of power semiconductor packages spaced apart from one another along the plate surface direction simultaneously.

Moreover, the upper channels and the lower channels of the power semiconductor package with the plurality of units may be respectively provided with connector coupling portions to which the connectors are coupled, and a connector sealant may be provided in a mutual contact region between the connector coupling portion and the connector, thereby suppressing the cooling fluid from leaking into a coupling region between the connector coupling portion and the connector.

Besides, when the plurality of power semiconductor packages are thermally deformed, the deformation may be absorbed by the slip of the connector, the connector coupling portion, and the connector sealant.

### Brief Description of Drawings

FIG. 1 is a perspective view of a double-side cooling power semiconductor package according to one embodiment of the present disclosure.
FIG. 2 is a cross-sectional view of the double-side cooling power semiconductor package of FIG. 1.
FIG. 3 is an enlarged view of a plurality of cooling channels in FIG. 2.
FIG. 4 is a perspective view of the power semiconductor package of FIG. 1.
FIG. 5 is a cross-sectional view of the power semiconductor package of FIG. 4.
FIGS. 6 and 7 are drawings showing examples of fixing members of the double-side cooling power semiconductor package of FIG. 1, respectively.
FIG. 8 is a view for explaining an operation of the double-side cooling power semiconductor package of FIG. 1.
FIG. 9 is a perspective view of a double-side cooling power semiconductor package according to another embodiment of the present disclosure.
FIG. 10 is a cross-sectional view of the double-side cooling power semiconductor package of FIG. 9.
FIG. 11 is an exploded perspective view of the double-side cooling power semiconductor package of FIG. 9.
FIG. 12 is an exploded perspective view of a power semiconductor package and a heat sink in FIG. 11.
FIG. 13 is a plan view and a side view of the heat sink of FIG. 12.
FIGS. 14 to 16 are plan views and side views, respectively, of modified examples of the heat sink of FIG. 13.
FIG. 17 is an exploded perspective view of an upper channel in FIG. 11.
FIG. 18 is a bottom view of a lower channel in FIG. 11.
FIG. 19 is a view for explaining an operation of the double-side cooling power semiconductor package of FIG. 9.
FIG. 20 is a perspective view of a double-side cooling power semiconductor package according to still another embodiment of the present disclosure.
FIG. 21 is a cross-sectional view of the double-side cooling power semiconductor package of FIG. 20.
FIG. 22 is a view for explaining an operation of the double-side cooling power semiconductor package of FIG. 20.
FIG. 23 is a cross-sectional view of a double-side cooling power semiconductor package according to still another embodiment of the present disclosure.
FIG. 24 is an enlarged view of lower and upper channels in FIG. 23.
FIG. 25 is an enlarged view of a power semiconductor package and a heat sink in FIG. 23.
FIG. 26 is a perspective view of a state in which the power semiconductor package and the heat sink of FIG. 24 are coupled to each other.
FIG. 27 is an exploded perspective view of a power semiconductor package and a heat sink in FIG. 24.
FIG. 28 is a view for explaining an operation of the double-side cooling power semiconductor package of FIG. 23.
FIG. 29 is a cross-sectional view of a double-side cooling power semiconductor package according to still another embodiment of the present disclosure.
FIG. 30 is an enlarged view of a connector and a connector coupling portion region upper cooler in FIG. 29.
FIG. 31 is a view for explaining an operation of the double-side cooling power semiconductor package of FIG. 28.

### Mode for the Invention

Hereinafter, embodiments disclosed herein will be described in detail with reference to the accompanying drawings. Herein, even in different embodiments, the same or similar reference numerals are designated to the same or similar configurations, and the description thereof will be substituted by the earlier description. A singular expression used herein may include a plural expression unless clearly defined otherwise in the context. In describing embodiments disclosed herein, moreover, the detailed description will be omitted when specific description for publicly known technologies to which the invention pertains is judged to obscure the gist of the present disclosure. Also, it should be noted that the accompanying drawings are merely illustrated to easily explain the concept of the invention, and therefore, they should not be construed to limit the technological concept disclosed herein by the accompanying drawings.

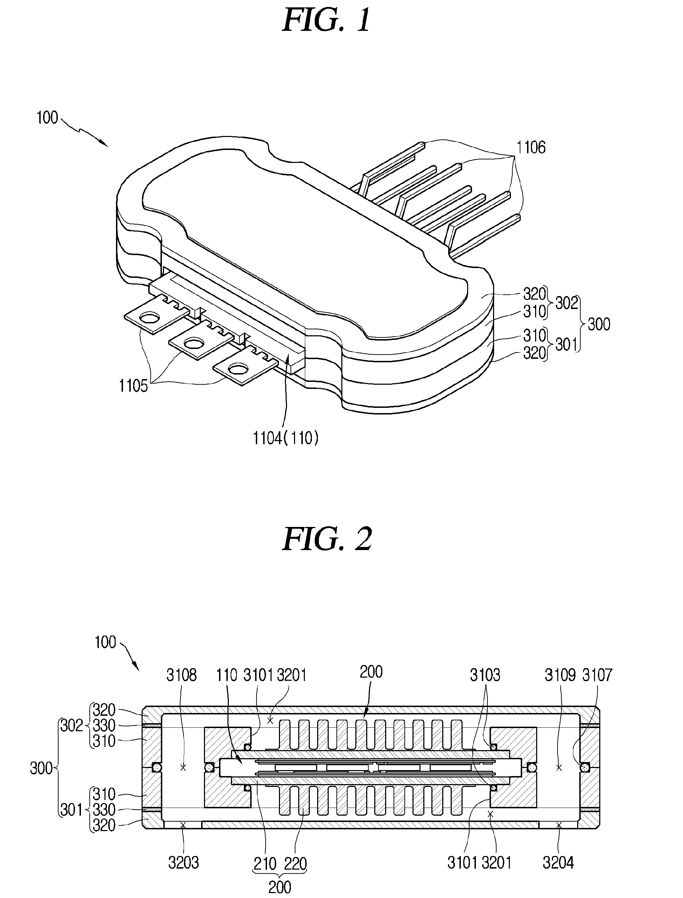

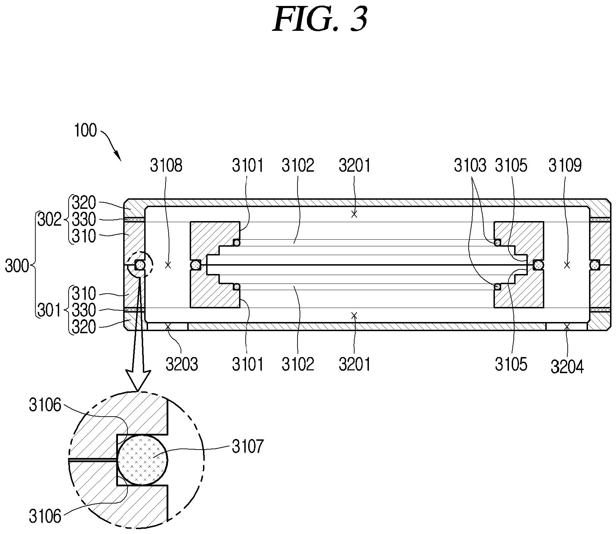

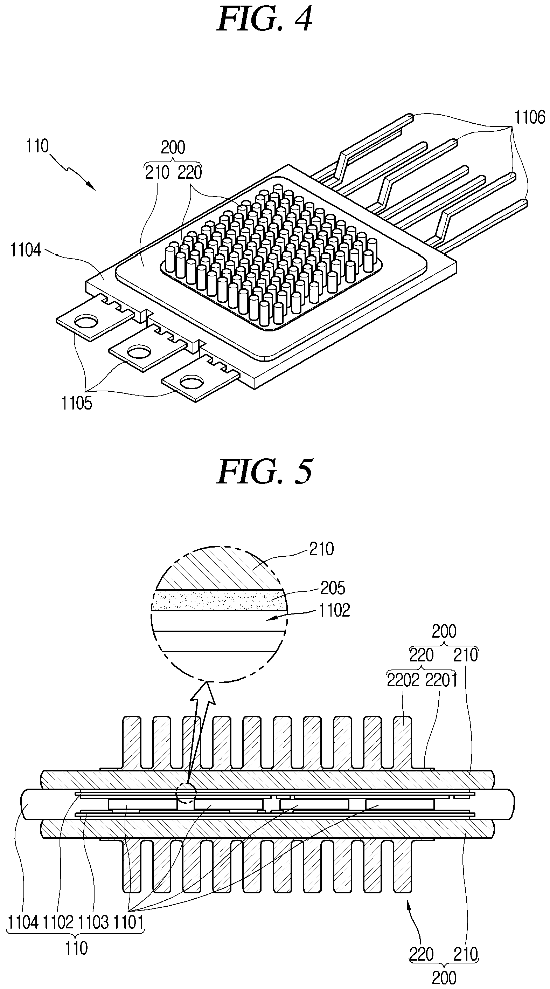

FIG. 1 is a perspective view of a double-side cooling power semiconductor package according to one embodiment of the present disclosure, FIG. 2 is a cross-sectional view of the double-side cooling power semiconductor package of FIG. 1, FIG. 3 is an enlarged view of a plurality of cooling channels in FIG. 2, FIG. 4 is a perspective view of the power semiconductor package of FIG. 1, FIG. 5 is a cross-sectional view of the power semiconductor package of FIG. 4, and FIGS. 6 and 7 are drawings showing examples of fixing members of the double-side cooling power semiconductor package of FIG. 1, respectively. As shown in FIGS. 1 to 5, a double-side cooling power semiconductor package 100 in this embodiment includes a power semiconductor package 110, a heat sink 200, and plurality of cooling channels 300.

The power semiconductor package 110 has a plate shape having a thin thickness.

The power semiconductor package 110 is configured with, for example, a plurality of circuit elements 1101, an upper substrate 1102 disposed on one side (an upper side in the drawing) along a thickness direction of the plurality of circuit elements 1101, and a lower substrate 1103 provided on a lower side of the plurality of circuit elements 1101.

The power semiconductor package 110 includes a packaging portion 1104 that wraps (packages) the plurality of circuit elements 1101, the upper substrate 1102, and the lower substrate 1103 into a single body. The packaging portion 1104 may be implemented, for example, in a rectangular parallelepiped shape having a relatively thin thickness.

Although not specifically shown in the drawing, the plurality of circuit elements 1101 are configured with, for example, an insulated gate bipolar transistor (IGBT) and a diode.

A plurality of power leads 1105 are provided, for example, on one side of the power semiconductor package 110. The plurality of power leads 1105 may each be implemented in a thin plate shape, for example.

A plurality of signal leads 1106 are provided, for example, on the other side of the power semiconductor package 110. The plurality of signal leads 1106 may each be implemented in a bar shape, for example.

Heat sinks 200 are respectively provided on both plate surfaces of the power semiconductor package 110.

Through this, the heat dissipation of the power semiconductor package 110 may be accelerated.

The heat sink 200 is formed of, for example, a metal member.

Accordingly, heat energy generated in the power semiconductor package 110 may be easily transferred to the heat sink 200.

The heat sink 200 may be configured with, for example, a plate 210 and a plurality of heat dissipation fins 220 protruding from the plate 210 in a thickness direction.

The plate 210 is implemented in a rectangular plate shape having a thin thickness, for example.

The plurality of heat dissipation fins 220 are configured with, for example, a coupling portion 2201 coupled to the plate 210 and a plurality of fins 2202 protruding from the coupling portion 2201 along a thickness direction. The plurality of fins 2202 are respectively disposed to be spaced apart from one another at preset intervals in horizontal and vertical directions of the coupling portion 2201.

The plate 210 may be configured to have a larger size than, for example, the upper substrate 1102 (lower substrate 1103) of the power semiconductor package 110.

Accordingly, since the plate 210 has a surface area larger than that of the upper substrate 1102 or the lower substrate 1103, heat energy transferred from the upper substrate 1102 or the lower substrate 1103 may be easily dissipated.

In addition, the plate 210 may be in close contact with an entire surface region of each surface of the upper substrate 1102 and the lower substrate 1103, thereby suppressing a local temperature on a surface of the power semiconductor package 110 from being increased.

According to this configuration, the heat energy of the power semiconductor package 110 may be quickly dissipated so as to maintain the temperature of the power semiconductor package 110 at a relatively low state. Through this, the possibility of occurrence of an error due to an excessive temperature rise (high temperature) of the power semiconductor package 110 may be reduced.

One side (inner side in the drawing) of the plate 210 of the heat sink 200 may be coupled in close contact with a surface of the power semiconductor package 110.

For example, a thermal interface material 205 may be inserted into a mutual contact region between the plate 210 and the power semiconductor package 110.

The heat transfer material 205 may be implemented as, for example, a thermal compound or thermal grease.

Accordingly, an amount of air in a mutual contact region between a surface of the power semiconductor package 110 and the plate 210 of the heat sink 200 may be reduced, thereby easily transferring heat energy generated in the power semiconductor package 110 to the heat sink 200 (plate 210).

The plate 210 of the heat sink 200 may be bonded to the surface of the power semiconductor package 110. Specifically, the plate 210 of the heat sink 200 and the surface of the power semiconductor package 110 may be coupled to each other by metal bonding (e.g., sintering, soldering or ultrasonic welding).

Through this, an amount of air between the plate 210 of the heat sink 200 and the surface of the power semiconductor package 110 may be reduced and an amount of metal, which is a heat conductor, may be increased so as to quickly and easily transfer the heat energy of the power semiconductor package 110 to the heat sink 200.

In this embodiment, a size and/or number of the plate 210 and the plurality of heat dissipation fins 220 of the heat sink 200 may be controlled in consideration of an amount of heat dissipation of the power semiconductor package 110.

When the amount of heat dissipation of the power semiconductor package 110 increases, the amount of heat dissipation of the heat sink 200 may be increased by increasing the size and number of the plate 210 and the plurality of heat dissipation fins 220.

Meanwhile, a plurality of cooling channels 300 are provided on both sides of the power semiconductor package 110.

As shown in FIG. 3, each of the plurality of cooling channels 300 is provided with a passage 3201 of cooling fluid thereinside.

The plurality of cooling channels 300 may be provided, for example, along a thickness direction of the power semiconductor package 110 on both sides thereof.

In this embodiment, each of the plurality of cooling channels 300 is provided with a through portion 3101 so as to receive one region of heat sinks 200 provided on both sides of the power semiconductor package 110.

Each of the plurality of cooling channels 300 is configured with, for example, a body 310 one side of which is in contact with the power semiconductor package 110 along a thickness direction, and a cover 320 coupled to the other side of the body 310 to form the passage 3201 of cooling fluid with respect to the body 310.

The cover 320 may be configured to have a thinner thickness than the body 310, for example.

The passage 3201 of cooling fluid is disposed inside the cover 320.

A body sealant 330 is provided in a mutual contact region between the cover 320 and the body 310.

The body sealant 330 may be formed of, for example, a sealing member having elasticity.

The body sealant 330 may be implemented in a loop shape corresponding to a rim shape of the body 310.

The body sealant 330 may be formed of, for example, a rubber member or a silicone member.

Accordingly, cooling fluid thereinside may be prevented from leaking to the outside through a gap between the body 310 and the cover 320.

The body 310 is provided with the through portion 3101.

The through portion 3101 has, for example, a rectangular shape.

The through portion 3101 is disposed to pass through the body 310 along a thickness direction.

Specifically, the plurality of cooling channels 300 include a lower channel 301 provided on one side (a lower side in the drawing) of the power semiconductor package 110 and an upper channel 302 provided on the other side (an upper side in the drawing).

Although not specifically shown in the drawing, each body 310 and cover 320 of the lower channel 301 and upper channel 302 may be configured to be integrally and fixedly coupled to each other by a plurality of fixing members that are disposed (formed) to be spaced apart from one another along a rim thereof.

In addition, the lower channel 301 and the upper channel 302 may be configured to be integrally and fixedly coupled to each other by a plurality of fixed members not shown.

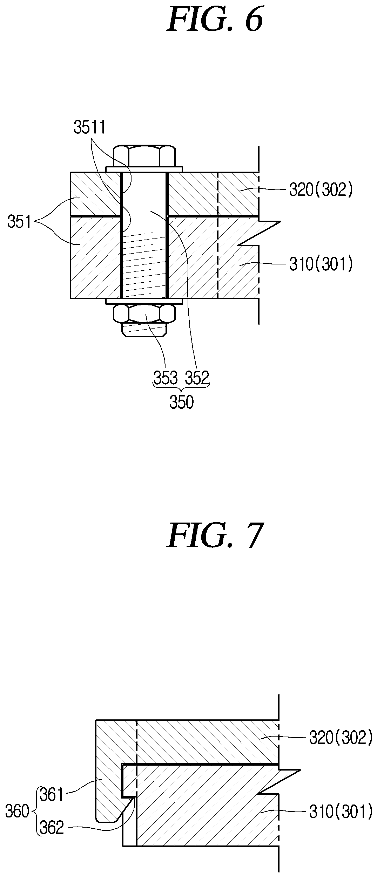

Here, for example, as shown in FIG. 6, a plurality of fixing members 350 may be configured to include bolts 352 and nuts 353 that are respectively screwed to each other. Specifically, a boss 351 having a bolt receiving hole 3511 may be disposed in each of the upper channel 302 and the lower channel 301 such that the bolt 352 can be received and coupled thereto, and the bolt 352 is coupled to the boss 351, and then the nut 353 is fastened thereto such that the upper channel 302 and the lower channel 301 are integrally and fixedly coupled to each other.

Additionally, for example, as shown in FIG. 7, a plurality of fixing members 360 may be configured to have hooks 3601 and hook engaging projections 3602 that are engaging with each other. Specifically, a hook 3601 may be disposed to extend along a thickness direction in either one of the upper channel 302 and the lower channel 301, and a hook engaging projection 3602 may be disposed in the other thereof such that the hook 3601 can be engaged therewith, such that the hook 3601 engages with the hook engaging projection 3602, thereby allowing the upper channel 302 and the lower channel 301 to be integrally and fixedly coupled to each other.

The lower channel 301 and upper channel 302 are configured with the body 310 and cover 320, respectively.

Here, the body 310 and cover 320 of each of the upper channel 302 and the lower channel 301 may be configured to be integrally and fixedly coupled to each other by forming the bosses 351 respectively and connecting the bolt 352 and nut 353 to the bosses 351, as shown in FIG. 6. In addition, the body 310 and cover 320 of each of the lower channel 301 and the upper channel 302 may be respectively provided with the hook 3601 and the hook engaging projection 3602 to be engaged with each other, as shown in FIG. 7, and configured to be integrally coupled to each other by engaging the body 310 and the cover 320 with the hook 3601 and the hook engaging projection 3602.

On one side of the lower channel 301, an inlet port 3203 is provided through which the cooling fluid flows in.

On the other side of the lower channel 301, an outlet port 3204 through which the cooling fluid flows out is provided.

The inlet port 3203 and outlet port 3204 are each provided in the cover 320 of the lower channel 301.

The inlet port 3203 and outlet port 3204 are each disposed to pass through the cover 320 of the lower channel 301 along a thickness direction.

The lower channel 301 and upper channel 302 are configured such that the cooling fluid flows into one end portion thereof along a length direction, and the cooling fluid thereinside flows out from the other end portion thereof.

The inlet-side and outlet-side end portions of the lower channel 301 and the upper channel 302 are each provided with protruding portions 3105 that protrude along a thickness direction to come into contact with each other.

Specifically, the protruding portions 3105 are disposed on the body 310 of the lower channel 301 and the body 310 of the upper channel 302, respectively.

An insertion space 315 into which the power semiconductor package 110 is inserted is disposed between the protruding portions 3105.

With reference to FIG. 2, the protruding portions 3105 are provided on both sides (left and right sides in the drawing) of the power semiconductor package 110.

The protruding portions 3105 are provided on both sides along a plate surface direction of the power semiconductor package 110.

Between the two protruding portions 3105, a power semiconductor package insertion space 315 is provided into which the power semiconductor package 110 is inserted.

An inlet passage 3108 communicating with the inlet port 3203 is disposed inside the protruding portion 3105 provided at an inlet-side end portion of the protruding portions 3105.

The inlet passage 3108 is disposed to pass through insides of the protruding portion 3105 of the lower channel 301 and the protruding portion 3105 of the upper channel 302, respectively.

The inlet passage 3108 is configured to communicate with the passage 3201 inside the lower channel 301 and the passage 3201 inside the upper channel 302.

Accordingly, the passage 3201 inside the lower channel 301 and the passage 3201 inside the upper channel 302 are connected in parallel with each other.

According to this configuration, refrigerant flowing into the inlet port 3203 is branched to move to the passage 3201 inside the lower channel 301 and the passage 3201 inside the upper channel 302, respectively.

An outlet passage 3109 communicating with the outlet port 3204 is disposed inside the protruding portion 3105 provided at an outlet-side end portion of the protruding portions 3105.

The outlet passage 3109 is disposed to pass through insides of the protruding portion 3105 of the lower channel 301 and the protruding portion 3105 of the upper channel 302, respectively.

In this embodiment, the passage 3201 of cooling fluid may be formed on both sides (left and right sides in the drawing) of the power semiconductor package insertion space 315, thereby accelerating the cooling of both sides of the power semiconductor package 110.

The mutual contact regions between the protruding portions 3105 are each provided with a protruding portion sealant 3107.

A protruding portion sealant receiving portion 3106 is provided in the mutual contact region between the protruding portions 3105 to receive the protruding portion sealant 3107.

The protruding sealant receiving portion 3106 is provided in each of the protruding portion 3105 of the lower channel 301 and the protruding portion 3105 of the upper channel 302.

Meanwhile, the body 310 of each of the cooling channels 300 (lower channel 301 and upper channel 302) is provided with an extension portion 3102 that is recessed in a thickness direction so as to have a size that is extended compared to that of the through portion 3101 around the through portion 3101.

In this embodiment, the plate 210 of the heat sink 200 is configured to have a larger size than the extension portion 3102.

An extension portion sealant 3103 that comes into contact with the heat sink 200 to suppress the leakage of the cooling fluid is provided inside the extension portion 3102.

Through this, the cooling fluid inside the lower channel 301 and upper channel 302 may be suppressed from leaking to the outside through the through portion 3101.

In addition, an entire section of the extension portion sealant 3103 may come into contact with the plate 210 of the heat sink 200, thereby suppressing forced deterioration due to high temperatures due to excessive local temperature rise from occurring.

The plate 210 of the heat sink 200 may come into direct contact with the cooling fluid, and heat energy may be quickly transferred to the plurality of heat dissipation fins 220 to suppress temperature rise so as to suppress the extension portion sealant 3103 from rising in temperature, thereby suppressing the occurrence of deformation due to high temperatures, and extending its service life.

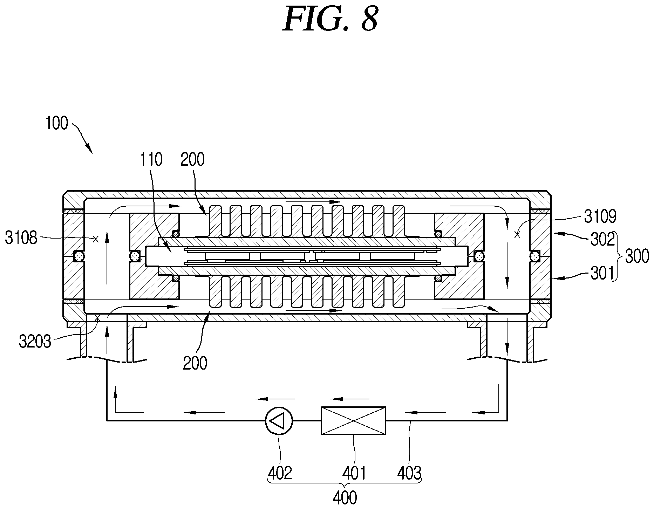

FIG. 8 is a view for explaining an operation of the double-side cooling power semiconductor package of FIG. 1. As shown in FIG. 8, the lower channel 301 may be disposed on a lower side of the power semiconductor package 110, and the heat sink 200 on the lower side of the power semiconductor package 110 may be inserted into and coupled to the through portion 3101 of the lower channel 301. The heat dissipation fins 220 of the heat sink 200 on a lower side of the power semiconductor package 110 are inserted into the through portion 3101 of the lower channel 301, and end portions thereof are respectively disposed in the passages 3201 inside the lower channel 301.

The upper channel 302 may be coupled to allow the heat sink 200 on an upper side of the power semiconductor package 110 to be inserted into the through portion 3101 of the upper channel 302. The heat dissipation fins 220 of the heat sink 200 on an upper side of the power semiconductor package 110 are each disposed in the passage 3201 inside the upper channel 302 through the through portion 3101 of the upper channel 302.

The inlet port 3203 and outlet port 3204 of the lower channel 301 are each connected to a cooling fluid circulation circuit 400 through which the cooling fluid circulates.

The cooling fluid circulation circuit 400 includes a pipe 403 through which the cooling fluid moves.

In this embodiment, the double-side cooling power semiconductor package 100 may be provided in, for example, an inverter of an electric vehicle. The cooling fluid circulation circuit 400 is provided in the electric vehicle, and the cooling fluid may be provided with coolant of the electric vehicle.

The cooling fluid circulation circuit 400 is provided with a heat exchanger 401 in which the cooling fluid is cooled through heat exchange.

The cooling fluid circulation circuit 400 is provided with a pump 402 that accelerates the movement of the cooling fluid.

The outlet port 3204 is connected to an upstream side of the heat exchanger 401 with respect to a movement direction of the cooling fluid moved by the pump 402. The inlet port 3203 of the lower channel 301 is connected to a downstream side of the heat exchanger 401.

When an operation is initiated, the power semiconductor package 110 generates heat energy by the heat generation of the plurality of circuit elements 1101. The heat energy generated from the plurality of circuit elements 1101 is transferred to the lower substrate 1103 and the upper substrate 1102, respectively, and the heat energy transferred to the lower substrate 1103 and the upper substrate 1102 is transferred to the heat sinks 200, respectively.

When an operation is initiated, the pump 402 is operated, and when the pump 402 is operated, the cooling fluid of the cooling fluid circulation circuit 400 moves.

The cooling fluid of the cooling fluid circulation circuit 400 is cooled through heat exchange while passing through the heat exchanger 401. The cooling fluid cooled in the heat exchanger 401 flows into the lower channel 301 through the inlet port 3203. Part of the cooling fluid that has flowed in absorbs heat energy generated in the power semiconductor package 110 while passing through the passage 3201 inside the lower channel 301. The cooling fluid that has absorbed the heat energy moves to the outlet port 3204 with an increased temperature.

Another part of the cooling fluid that has flowed in through the inlet port 3203 moves along the passage 3201 of the upper channel 302 by way of the inlet passage 3108. The cooling fluid moving along the passage of the upper channel 302 absorbs heat energy generated in the power semiconductor package 110 to cool the power semiconductor package 110. The cooling fluid, whose temperature has increased by absorbing heat energy inside the upper channel 302, moves to the outlet port 3204 by way of the outlet passage 3109.

The cooling fluid flowing out through the outlet port 3204 continuously cools the power semiconductor package 110 while repeating a process of cooling while passing through the heat exchanger 401, and flowing into the outlet port 3204 to absorb the heat energy generated in the power semiconductor package 110 while passing through the lower channel 301 and the upper channel 302, respectively.

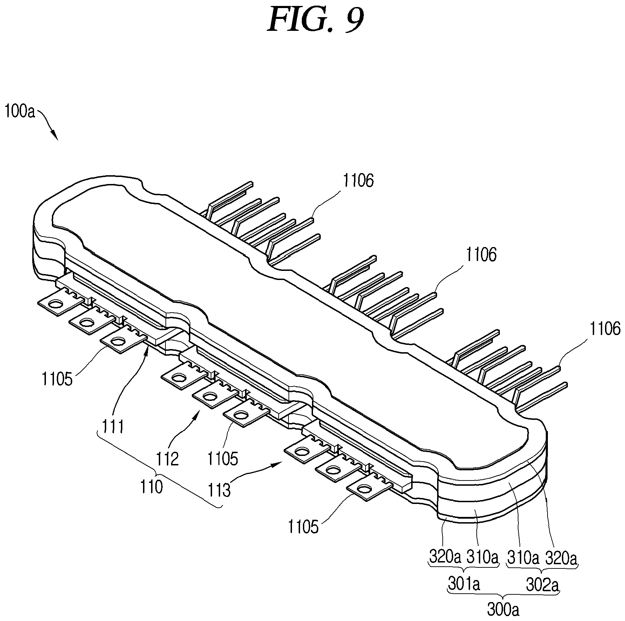

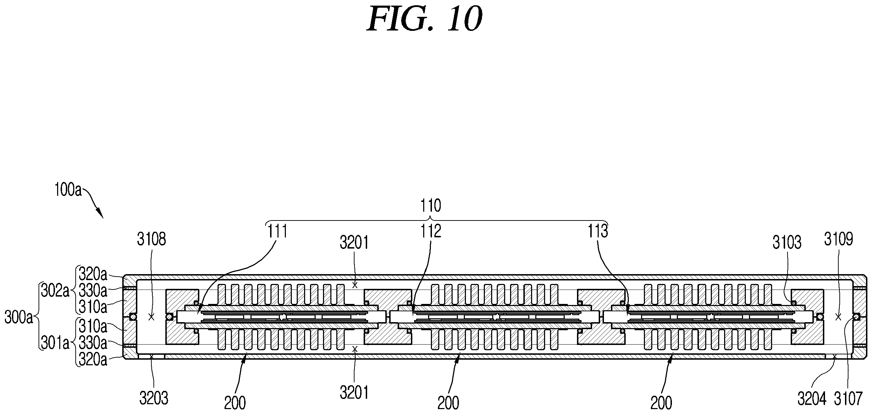

FIG. 9 is a perspective view of a double-side cooling power semiconductor package according to another embodiment of the present disclosure, and FIG. 10 is a cross-sectional view of the double-side cooling power semiconductor package of FIG. 9. As shown in FIGS. 9 and 10, a double-side cooling power semiconductor package 100a in this embodiment includes a power semiconductor package 110, a heat sink 200, and plurality of cooling channels 300a.

The power semiconductor package 110 has a plate shape.

The power semiconductor package 110 includes, for example, a plurality of circuit elements 1101, an upper substrate 1102 provided on an upper side of the plurality of circuit elements 1101, and a lower substrate 1103 provided on a lower side of the plurality of circuit elements 1101.

The power semiconductor package 110 includes a packaging portion 1104 that wraps (packages) the plurality of circuit elements 1101, the upper substrate 1102, and the lower substrate 1103 into a single body. The packaging portion 1104 is implemented, for example, in a rectangular parallelepiped shape having a relatively thin thickness.

A plurality of power leads 1105 are provided on one side of the power semiconductor package 110, and a plurality of signal leads 1106 are provided on the other side thereof.

In this embodiment, the power semiconductor package 110 is configured with a plurality of power semiconductor packages 110 disposed to be spaced apart from one another along a plate surface direction.

The plurality of power semiconductor packages 110 are configured with, for example, a first power semiconductor package 111, a second power semiconductor package 112, and a third power semiconductor package .

In this embodiment, it is illustrated a case where the plurality of power semiconductor packages 110 are implemented with three units, but this is only an example and is not limited thereto.

Heat sinks 200 are provided on both sides of the each power semiconductor package 110.

The heat sink 200 includes, for example, a plate 210 having a thin rectangular shape and a plurality of heat dissipation fins 220 protruding along a thickness direction of the plate 210.

On both sides of the power semiconductor package 110, a plurality of cooling channels 300a having a passage 3201 of cooling fluid thereinside are provided.

The plurality of cooling channels 300a are each provided with a through portion 3101 to allow one region of the heat sink 200 to be inserted thereinto.

In this embodiment, the plurality of cooling channels 300a include, for example, a lower channel 301a provided on a lower side of the power semiconductor package 110 and an upper channel 302a provided on an upper side thereof.

The plurality of cooling channels 300a (lower channel 301a, upper channel 302a) may each be configured with a body 310a one side of which is in contact with the power semiconductor package 110 along a thickness direction, and a cover 320a coupled to the other side of the body 310a to form the passage 3201 of cooling fluid with respect to the body 310a.

Although not specifically shown in the drawing, the body 310a and the cover 320a of the lower channel 301a and the body 310a and the cover 320a of the upper channel 302a may be configured to be integrally coupled to each other by a plurality of fixing members (e.g., bolts and nuts in FIG. 7), which are not shown herein. In addition, the lower channel 301a and the upper channel 302a may be configured to be integrally coupled to each other by a plurality of fixing members (e.g., hooks and hook engaging projections in FIG. 8), which are not shown herein.

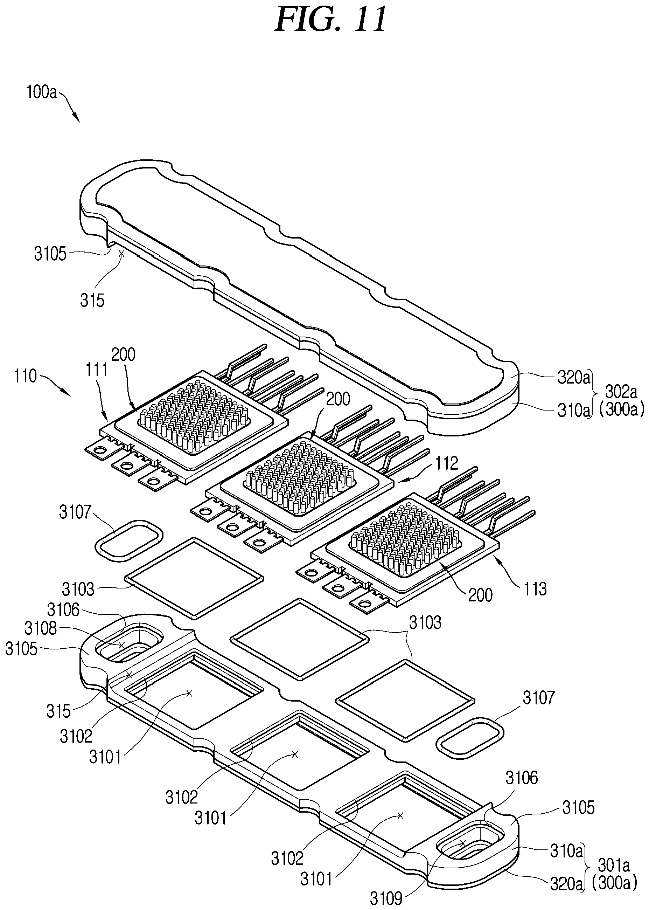

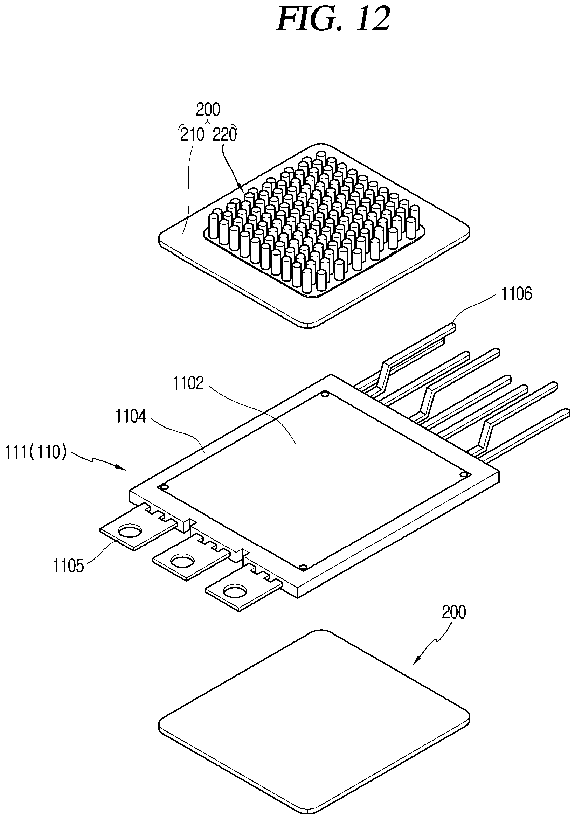

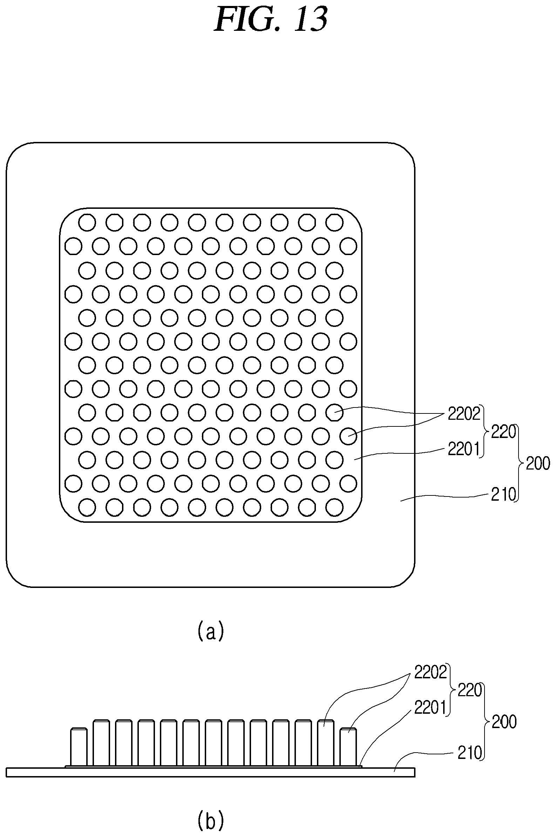

FIG. 11 is an exploded perspective view of the double-side cooling power semiconductor package of FIG. 9, FIG. 12 is an exploded perspective view of a power semiconductor package and a heat sink in FIG. 11, FIG. 13 is a plan view and a side view of the heat sink of FIG. 12, and FIGS. 14 to 16 are plan views and side views, respectively, of modified examples of the heat sink of FIG. 13. As shown in FIG. 11 and FIG. 12, the lower channel 301a and the upper channel 302a are each provided with a plurality of through portions 3101 to allow the first power semiconductor package 111, the second power semiconductor package 112, and the third power semiconductor package 113 to be inserted thereinto. In this embodiment, the plurality of through portions 3101 are configured with three units.

Each body 310a of the lower channel 301a and the upper channel 302a is provided with an extension portion 3102 that is recessed in a thickness direction with a size that is extended compared to that of the through portion 3101 around the plurality of through portions 3101.

An extension portion sealant 3103 that comes into contact with the heat sink 200 to suppress the leakage of the cooling fluid is provided inside the extension portion 3102.

The lower channel 301a and upper channel 302a are configured such that the cooling fluid flows into one end portion thereof along a length direction, and the cooling fluid thereinside flows out from the other end portion thereof.

The inlet-side and outlet-side end portions of the lower channel 301a and the upper channel 302a are each provided with protruding portions 3105 that respectively protrude along a thickness direction to come into contact with each other.

An inlet passage 3108 is disposed inside the protruding portion 3105 provided on the inlet-side end portion.

The inlet passage 3108 is connected in communication with the passage 3201 inside the lower channel 301a and the passage 3201 of the upper channel 302a, respectively.

Through this, the passage 3201 inside the lower channel 301a and the passage 3201 of the upper channel 302a are connected in parallel with each other.

An outlet passage 3109 is disposed inside the protruding portion 3105 provided on the outlet-side end portion.

The mutual contact regions between the protruding portions 3105 are each provided with a protruding portion sealant 3107 that suppresses the leakage of cooling fluid.

A protruding portion sealant receiving portion 3106 is provided in the mutual contact region between the respective protruding portions 3105 to receive the protruding portion sealant 3107.

The protruding sealant receiving portions 3106 respectively communicate with the inlet passage 3108 (outlet passage 3109) and are disposed to be recessed to have a size that is extended compared to that of the inlet passage 3108 (outlet passage 3109).

That is, the protruding portion sealant receiving portion 3106 is disposed to be recessed downward in the protruding portion 3105 of the body 310a of the lower channel 301a, and the protruding portion sealant receiving portion 3106 is disposed to be recessed upward in the protruding portion 3105 of the body 310a of the upper channel 302a.

As shown in FIG. 12, the power semiconductor package 110 has a rectangular plate shape having a thin thickness. A plurality of power leads 1105 are provided on one side of the power semiconductor package 110, and a plurality of signal leads 1106 are provided on the other side thereof. The plurality of power leads 1105 may each be implemented in a thin plate shape, and the plurality of signal leads 1106 may each be implemented in a rod shape.

The heat sinks 200 are respectively provided on both plate surfaces of the power semiconductor package 110.

The heat sink 200, as shown in FIG. 13, includes a rectangular plate-shaped plate 210 and a plurality of heat dissipation fins 220 protruding in a thickness direction from the plate 210. The plurality of heat dissipation fins 220 includes a coupling portion 2201 that is coupled in contact with the plate 210 and a plurality of fins 2202 that protrude from the coupling portion 2201. The plurality of fins 2202 may each be implemented in a bar shape having a circular cross-section, for example.

Here, the coupling portion 2201 is configured in a reduced rectangular shape compared to the plate 210. The plurality of fins 2202 may be configured to have different numbers, for example, depending on the column. Additionally, the plurality of fins 2202 may be configured such that the fins of a row disposed behind the preceding row are disposed in a zigzag pattern between the fins of the preceding row. The plurality of fins 2202 may be configured to have different heights.

In this embodiment, in the case of the plurality of fins 2202, the height of the fins 2202 disposed on both sides perpendicular to a movement direction of the cooling fluid is shown to be low, but this is only an example and is not limited thereto.

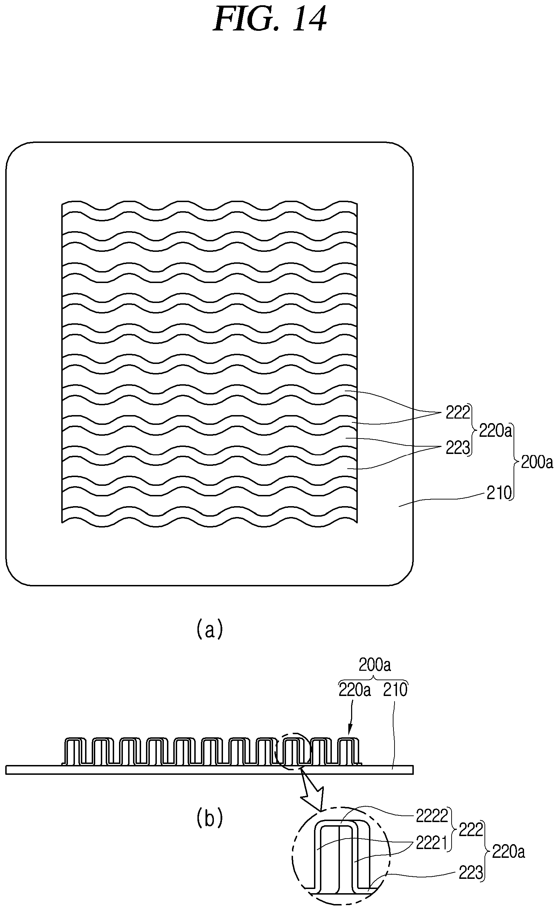

Meanwhile, as shown in FIG. 14, the heat sink 200a includes a rectangular plate-shaped plate 210 and a plurality of heat dissipation fins 220a protruding from a surface of the plate 210 in a thickness direction.

In this embodiment, the plurality of heat dissipation fins 220a include a plurality of protruding portions 222 protruding from the plate 210 and a coupling portion 223 coupled to the plate 210.

The protruding portions 222 and the coupling portions 223 are alternately disposed in a direction perpendicular to a movement direction of the cooling fluid, for example.

The protruding portion 222 includes, for example, both side wall portions 2221 and a connecting portion 2222 that connects upper ends of the both side wall portions 2221 so as to form a passage 3201 of cooling fluid thereinside.

The protruding portion 222 may be formed by bending to have a wave shape along a movement direction of the cooling fluid.

Through this, a surface area of the protruding portion 222 may be increased so as to increase an amount of heat exchange with the cooling fluid.

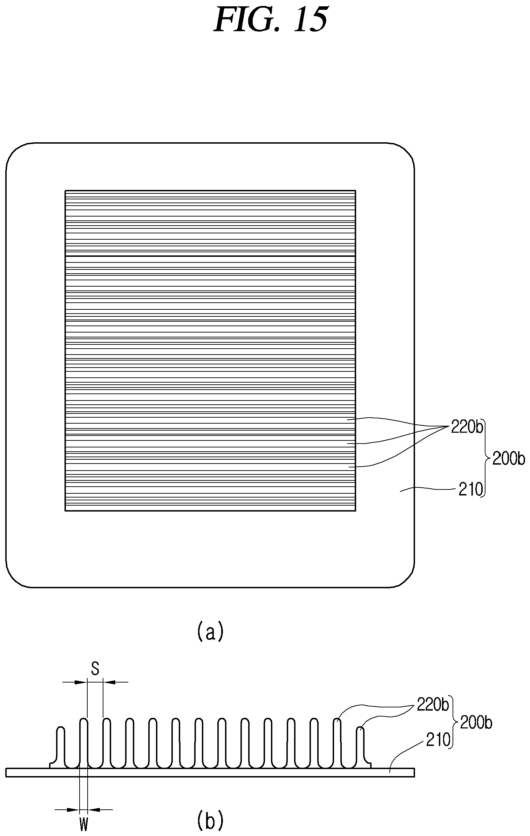

As shown in FIG. 15, the heat sink 200b includes a rectangular plate-shaped plate 210 and a plurality of heat dissipation fins 220b protruding from the plate 210 and extending in one direction.

The plurality of heat dissipation fins 220b are spaced apart at a preset spacing distance S.

In this embodiment, the spacing distance S of the plurality of heat dissipation fins 220 is disposed to be larger than a cross-sectional width w of the plurality of heat dissipation fins 220.

Accordingly, the heat sink 200 in this embodiment may be extruded so as to easily carry out the manufacture of the heat sink 200b.

In this embodiment, an extension direction of the plurality of heat dissipation fins 220b may be disposed along a movement direction of the cooling fluid.

According to this configuration, as the cooling fluid moves between the plurality of heat dissipation fins 220b, heat may be exchanged between the cooling fluid and the plurality of heat dissipation fins 220b.

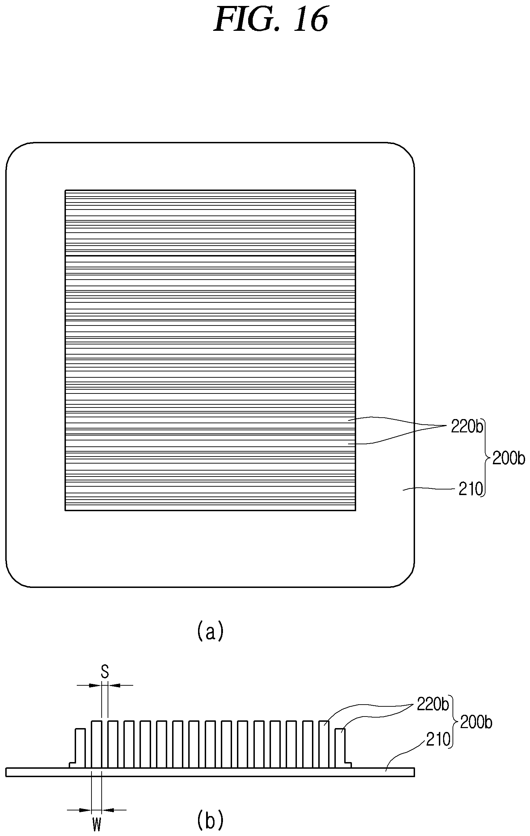

As shown in FIG. 16, the heat sink 200c includes a rectangular plate-shaped plate 210 and a plurality of heat dissipation fins 220c protruding in a thickness direction and extending in one direction from the plate 210.

The plurality of heat dissipation fins 220c are spaced apart at a preset spacing distance.

In this embodiment, the spacing distance S of the plurality of heat dissipation fins 220 may be disposed to be less than or equal to a cross-sectional width w of the plurality of heat dissipation fins 220.

Accordingly, a number of the plurality of heat dissipation fins 220c per unit area may be increased so as to significantly increase an amount of heat exchange between the plurality of heat dissipation fins 220c and the cooling fluid.

Meanwhile, the heat sink 200, as described above, may be coupled to a surface of the power semiconductor package 110 by metal bonding (e.g., sintering, soldering or ultrasonic welding).

Additionally, a heat transfer material 205 may be inserted into a mutual contact region between the heat sink 200 and the power semiconductor package 110.

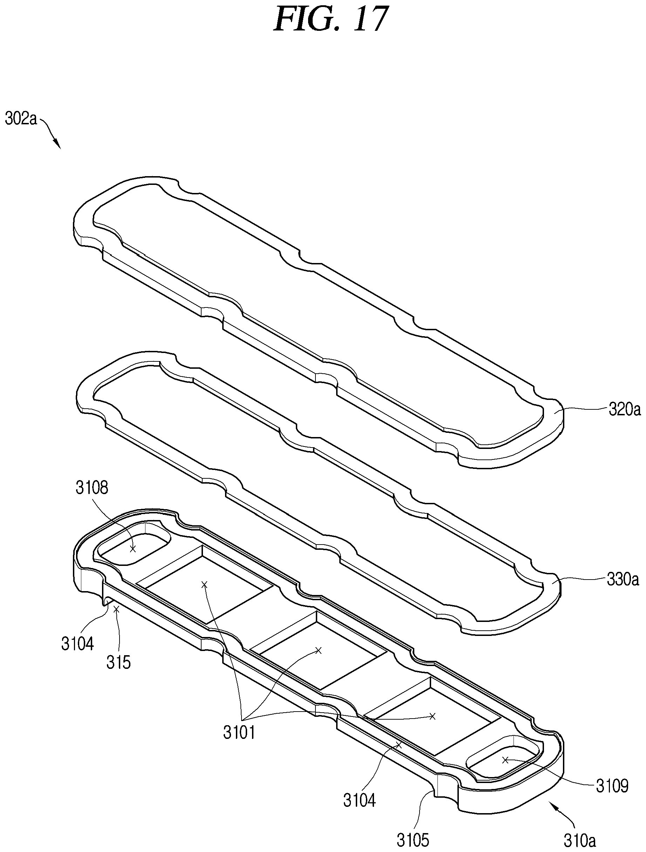

FIG. 17 is an exploded perspective view of an upper channel in FIG. 11. As shown in FIG. 17, the upper channel 302a includes a body 310a one side of which is in contact with the power semiconductor package 110 and a cover 320a coupled to the other side of the body 310a to form the passage 3201 of cooling fluid with respect to the body 310a.

A body sealant 330a is provided in a mutual contact region between the body 310a and the cover 320a.

The body sealant 330a is implemented as a sealing member having elasticity.

The body sealant 330a is formed of, for example, a rubber member.

The body sealant 330a has, for example, a loop shape corresponding to a rim shape of the body 310a.

The body 310a is provided with a body sealant receiving portion 3104 to allow, for example, the body sealant 330a to be inserted thereinto.

The body sealant 330a is configured such that one side (a bottom portion in the drawing) thereof is received in the body sealant receiving portion 3104 and the other side thereof can protrude outward from the body sealant receiving portion 3104.

A region protruding from the body sealant receiving portion 3104 of the body sealant 330a comes into close contact with the cover 320a of the upper channel 302a. Through this, the cooling fluid may be suppressed from leaking between the body 310a and the cover 320a of the upper channel 302a.

A protruding portion 3105 is disposed to protrude downward at each of the inlet-side and outlet-side end portions of the body 310a of the upper channel 302a.

An inlet passage 3108 and an outlet passage 3109 are each disposed to pass through an inside of the protruding portion 3105.

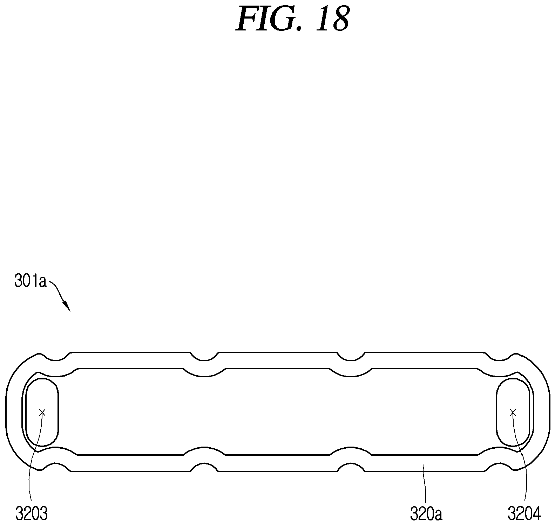

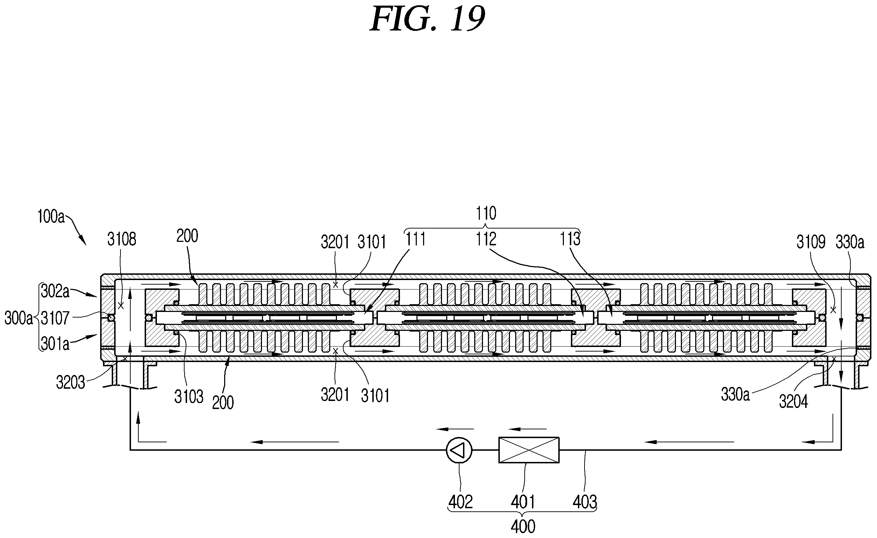

FIG. 18 is a bottom view of a lower channel in FIG. 11, and FIG. 19 is a view for explaining an operation of the double-side cooling power semiconductor package of FIG. 9. As shown in FIG. 18, the lower channel 301a is provided with an inlet port 3203 through which the cooling fluid flows in and an outlet port 3204 through which the cooling fluid flows out.

The inlet port 3203 and the outlet port 3204 are disposed to pass through the cover 320a of the lower channel 301a.

As shown in FIG. 19, the heat sinks 200 of the first power semiconductor package 111, the second power semiconductor package 112, and the third power semiconductor package 113 may be inserted into and coupled to the through portions 3101 of the lower channel 301a.

The upper channel 302a is coupled to an upper side of each of the each power semiconductor package 110 to allow each heat sink 200 to be inserted into the corresponding through portion 3101.

Meanwhile, the double-side cooling power semiconductor package 100a may be connected to a cooling fluid circulation circuit 400.

The cooling fluid circulation circuit 400 includes a pipe 403 through which the cooling fluid moves.

The inlet port 3203 and outlet port 3204 of the lower channel 301a are each connected to the cooling fluid circulation circuit 400.

The cooling fluid circulation circuit 400 includes, for example, a heat exchanger 401 in which the cooling fluid is cooled and a pump 402 that accelerates the movement of the cooling fluid.

When an operation is initiated, the plurality of power semiconductor package 110 respectively generates heat energy by the heat generation of the plurality of circuit elements 1101. The heat energy is transferred to the heat sinks 200 on lower and upper sides of the respective power semiconductor packages 111, 112, 113.

When an operation is initiated, the pump 402 of the cooling fluid circulation circuit 400 is operated to move the cooling fluid. The cooling fluid cooled in the heat exchanger 401 flows in through the inlet port 3203 of the lower channel 301a. Part of the cooling fluid flowing into the inlet port 3203 moves along an inside of the lower channel 301a. Another part of the cooling fluid flowing into the inlet port 3203 moves into the upper channel 302a.

The cooling fluid of the lower channel 301a comes into contact with the heat sink 200 provided on a lower surface of each of the first power semiconductor package 111, the second power semiconductor package 112, and the third power semiconductor package 113 and absorbs heat energy to cool the heat sink 200.

The cooling fluid of the upper channel 302a comes into contact with the heat sink 200 provided on an upper surface of each of the first power semiconductor package 111, the second power semiconductor package 112, and the third power semiconductor package 113 and absorbs heat energy to cool the heat sink 200.

Through this, the occurrence of a temperature deviation between lower and upper surfaces of the each power semiconductor package 110 may be suppressed.

The cooling fluid passing through the lower channel 301a and upper channel 302a flows out of the lower channel 301a through the outlet port 3204 and moves to the cooling fluid circulation circuit 400.

The cooling fluid moved to the cooling fluid circulation circuit 400 continuously cools the plurality of power semiconductor packages 110 while repeating a process of dissipating heat and cooling while passing through the heat exchanger 401, and allowing the cooled cooling fluid to flow into the inlet port 3203 and move to the lower channel 301a and the upper channel 302a, respectively, to absorb heat energy.

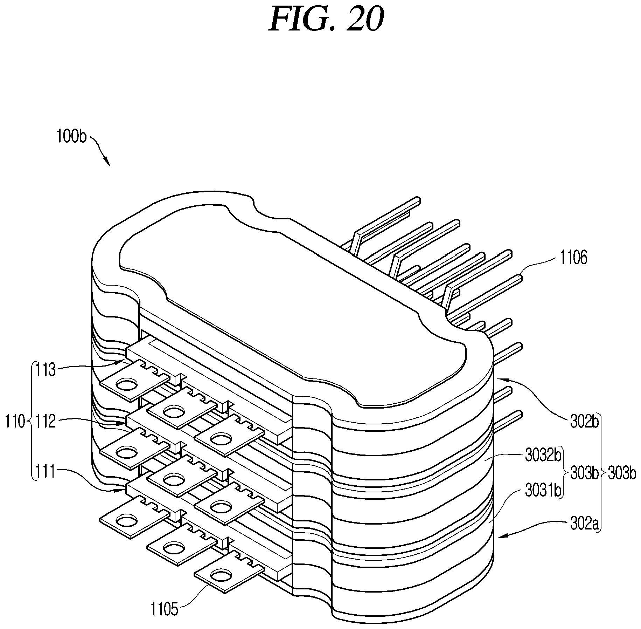

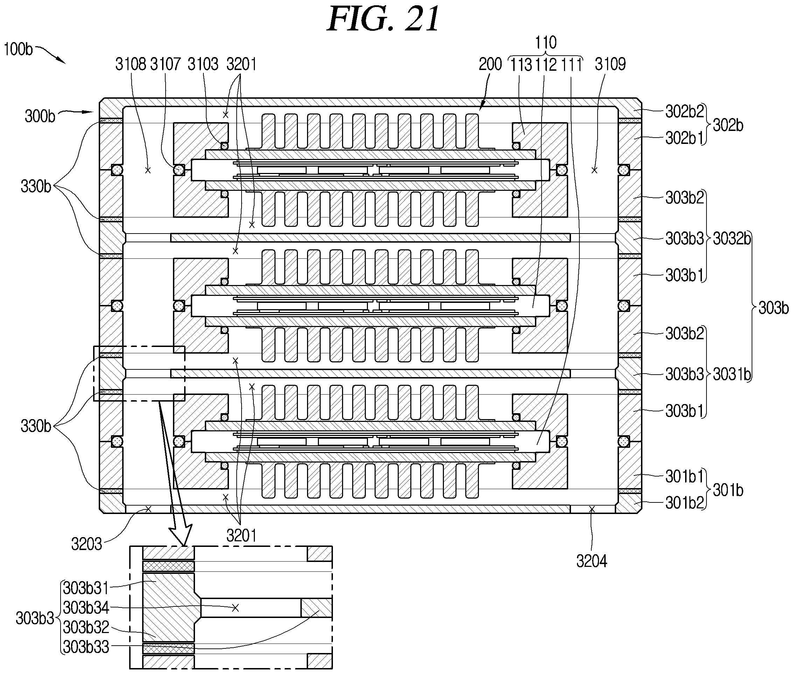

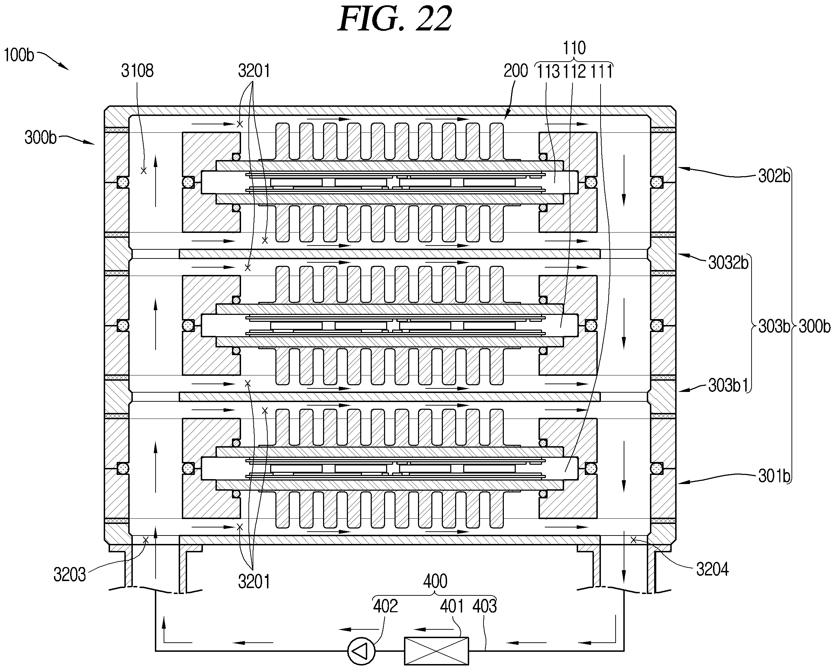

FIG. 20 is a perspective view of a double-side cooling power semiconductor package according to still another embodiment of the present disclosure, FIG. 21 is a cross-sectional view of the double-side cooling power semiconductor package of FIG. 20, and FIG. 22 is a view for explaining an operation of the double-side cooling power semiconductor package of FIG. 20. As shown in FIGS. 20 and 21, a double-side cooling power semiconductor package 100b in this embodiment includes a power semiconductor package 110, a heat sink 200, and plurality of cooling channels 300b.

The power semiconductor package 110 includes, for example, a plurality of circuit elements 1101, an upper substrate 1102 provided on an upper side of the plurality of circuit elements 1101, and a lower substrate 1103 provided on a lower side of the plurality of circuit elements 1101.

The power semiconductor package 110 includes a packaging portion 1104 that wraps (packages) the plurality of circuit elements 1101, the upper substrate 1102, and the lower substrate 1103 into a single body. The packaging portion 1104 is implemented, for example, in a rectangular parallelepiped shape having a relatively thin thickness.

The power semiconductor package 110 may be configured with a plurality of units, for example, spaced apart from one another along a thickness direction.

In this embodiment, the power semiconductor package 110 includes a first power semiconductor package 111, a second power semiconductor package 112, and a third power semiconductor package 113 disposed to be spaced apart from one another along a thickness direction.

Heat sinks 200 are respectively provided on both plate surfaces of the power semiconductor package 110.

The heat sink 200 includes, for example, a plate 210 that comes into contact with a surface of the power semiconductor package 110 and a plurality of heat dissipation fins 220 that protrude from a surface of the plate 210 in a thickness direction.

The plurality of cooling channels 300b include, for example, a lower channel 301b disposed at a lowermost side of the plurality of power semiconductor packages 110.

The plurality of cooling channels 300b include, for example, an upper channel 302b disposed at an uppermost side of the plurality of power semiconductor packages 110.

The plurality of cooling channels 300b include, for example, an intermediate channel 303b disposed in the middle of the plurality of power semiconductor packages 110.

Specifically, the lower channel 301b includes a lower body 301b1 that comes into contact with a lower side of the power semiconductor package 110 and a lower cover 301b2 that is coupled to the lower body 301b1 to form a passage 3201 of cooling fluid.

The lower channel 301b is provided on a lower side of the first power semiconductor package 111.

A body sealant 330b having a shape corresponding to a shape of the lower body 301b1 is provided in a mutual contact region between the lower body 301b1 and the lower cover 301b2.

Through this, cooling fluid may be suppressed from leaking between the lower body 301b1 and the lower cover 301b2.

The upper channel 302b includes, for example, an upper body 302b1 provided at an uppermost side of the plurality of power semiconductor packages 110 and an upper cover 302b2 coupled to the upper body 302b1 to form a passage 3201 of cooling fluid thereinside.

A body sealant 330b having a shape corresponding to a shape of the upper body 302b1 is provided in a mutual contact region between the upper body 302b1 and the upper cover 302b2.

Through this, cooling fluid may be suppressed from leaking between the upper body 302b1 and the upper cover 302b2.

The upper channel 302b is provided on an upper side of the third power semiconductor package 113.

The upper body 302b1 is provided with a through portion 3101 to allow the heat sink 200 of the power semiconductor package 110 to be inserted thereinto.

The intermediate channel 303b is provided in the middle of each of the plurality of power semiconductor packages 110 spaced apart from one another in a thickness direction.

In this embodiment, the intermediate channel 303b includes a first intermediate channel 3031b provided between the first power semiconductor package 111 and the second power semiconductor package 112, and a second intermediate channel 3032b provided between the second power semiconductor package 112 and the third power semiconductor package 113.

The intermediate channel 303b includes, for example, an upper body 303b1 provided on an upper side of the plurality of power semiconductor packages 110 spaced apart from one another along a thickness direction, a lower body 303b2 spaced apart from an upper side of the upper body 303b1, and an intermediate cover 303b3 inserted between the upper body 303b1 and the lower body 303b2.

The upper bodies 303b1 of the intermediate channel 303b are provided on an upper side of the first power semiconductor package 111 and an upper side of the second power semiconductor package 112, respectively.

The lower bodies 303b2 of the intermediate channel 303b are provided on a lower side of the second power semiconductor package 112 and a lower side of the third power semiconductor package 113, respectively.

The intermediate covers 303b3 of the intermediate channel 303b are provided between the first power semiconductor package 111 and the second power semiconductor package 112 and between the second power semiconductor package 112 and the third power semiconductor package 113, respectively.

The body sealants 330b are provided between the lower body 303b1 and the intermediate cover 303b3 and between the intermediate cover 303b3 and the upper body 303b1, respectively, in the intermediate channel 303b.

Through this, the occurrence of leakage of the cooling fluid may be suppressed.

In this embodiment, the lower body 303b2, the intermediate cover 303b3, and the upper body 303b1 are configured with the same outer surface, as shown in FIG. 20.

In this embodiment, the lower bodies 301b1, 303b2 and upper bodies 302b1, 303b1 of the lower channel 301b, upper channel 302b, and intermediate channel 303b are respectively provided with through portions 3101 to allow heat sinks 200 provided on lower and upper surfaces of the each power semiconductor package 110 to be inserted thereinto.

Around a circumference of each of the through portions 3101, an extension portion 3102 that is recessed along a thickness direction with a size that is extended compared to that of the through portion 3101 is provided.

Extension portion sealants 3103 that come into contact with the corresponding heat sinks 200 to suppress the leakage of the cooling fluid are each provided inside the extension portion 3102.

The plurality of cooling channels 300b are provided with an inlet port 3203 to allow the cooling fluid to flow thereinto.

The plurality of cooling channels 300b are provided with an outlet port 3204 to allow the cooling fluid thereinside to flow out to the outside.

The inlet port 3203 is provided, for example, in the lower channel 301b.

The outlet port 3204 is provided, for example, in the lower channel 301b.

The inlet port 3203 and outlet port 3204 are each disposed, for example, to pass through the lower cover 301b2 of the lower channel 301b.

In the respective lower bodies 301b1, 303b2 and upper bodies 302b1, 303b1 of the lower channel 301b, the intermediate channel 303b, and the upper channel 302b, the inlet passages 3108 passing therethrough along a thickness direction so as to correspond to the inlet port 3203 are respectively disposed.

In the respective lower bodies 301b1, 303b2 and upper bodies 302b1, 303b1 of the lower channel 301b, the intermediate channel 303b, and the upper channel 302b, the outlet passage 3109 passing therethrough along a thickness direction so as to correspond to the outlet port 3204 are respectively disposed.

The respective lower bodies 301b1, 303b2 and upper bodies 302b1, 303b1 of the lower channel 301b, the intermediate channel 303b and the upper channel 302b are respectively provided with protruding portions 3105 protruding therefrom along a thickness direction to come into contact with each other.

Between the protruding portions 3105 on both sides thereof, a power semiconductor package insertion space 315 into which the each power semiconductor package 110 is inserted is formed.

The protruding portions 3105 are respectively provided at inlet-side and outlet-side end portions of the respective lower bodies 301b1, 303b2 and the upper bodies 302b1, 303b1.

A protruding portion sealant 3107 that suppresses the leakage of the cooling fluid is provided in a mutual contact region between the protruding portions 3105 of the respective lower bodies 301b1, 303b2 and upper bodies 302b1, 303b1.

A protruding portion sealant receiving portion 3106 that is recessed to receive the protruding portion sealant 3107 is provided in a mutual contact region between the respective protruding portions 3105.

With this configuration, the heat sink 200 on a lower side of the first power semiconductor package 111 is inserted into and coupled to the through portion 3101 of the lower channel 301b, and the upper body 302b1 of the first intermediate channel 3031b is coupled to the heat sink 200 on an upper side of the first power semiconductor package 111.

The heat sink 200 on a lower side of the second power semiconductor package 112 is coupled to the lower body 301b1 of the first intermediate channel 3031b. The heat sink 200 on an upper side of the second power semiconductor package 112 is coupled to the upper body 302b1 of the second intermediate channel 3032b.

A heat sink 200 on a lower side of the third power semiconductor package 113 is coupled to the lower body 301b1 of the second intermediate channel 3032b. The heat sink 200 on an upper side of the third power semiconductor package 113 is coupled to the upper channel 302b.

Meanwhile, as shown in FIG. 22, the double-side cooling power semiconductor package 110 in this embodiment may be connected to a cooling fluid circulation circuit 400.

The cooling fluid circulation circuit 400 includes a pipe 403 through which the cooling fluid moves.

The cooling fluid circulation circuit 400 includes a heat exchanger 401 in which the cooling fluid is cooled through heat exchange and a pump 402 that accelerates the movement of the cooling fluid.

When an operation is initiated, heat energy is generated by the heat generation of the plurality of circuit elements 1101 in the each power semiconductor package 110.

The heat energy generated in the circuit elements 1101 in the each power semiconductor package 110 is transferred to the heat sinks 200 provided on both sides thereof.

When an operation is initiated, the pump 402 is operated, and the cooling fluid of the cooling fluid circulation circuit 400 is cooled through heat dissipation while passing through the heat exchanger 401. The cooling fluid passing through the heat exchanger 401 flows into the inlet port 3203, and part of the cooling fluid flowing into the lower channel 301b absorbs heat energy while moving along the passage of the lower channel 301b.

Another part of the cooling fluid flowing in through the inlet port 3203 is branched to move to the first intermediate channel 3031b, the second intermediate channel 3032b, and the upper channel 302b, respectively, while moving along the inlet passage 3108.

The cooling fluid flowing into the first intermediate channel 3031b, the second intermediate channel 3032b, and the upper channel 302b absorbs heat energy to cool the corresponding heat sinks 200, respectively, while moving along the corresponding passages.

Through this, the occurrence of temperature deviations between respective low and upper surfaces of the first power semiconductor package 111, the second power semiconductor package 112, and the third power semiconductor package 113 may be respectively suppressed.

The cooling fluid, whose temperature has increased by absorbing heat energy while moving along the respective passages of the lower channel 301b, the first intermediate channel 3031b, the second intermediate channel 3032b, and the upper channel 302b, moves along the outlet channel 3109 and moves to the cooling fluid circulation circuit 400 through the outlet port 3204.

The cooling fluid moved to the cooling fluid circulation circuit 400 continuously cools each power semiconductor package 110 while repeating a process of cooling in the heat exchanger 401, and flowing into the inlet port 3203 to absorb heat energy while moving along the lower channel 301b, the first intermediate channel 3031b, the second intermediate channel 3032b, and the upper channel 302b.

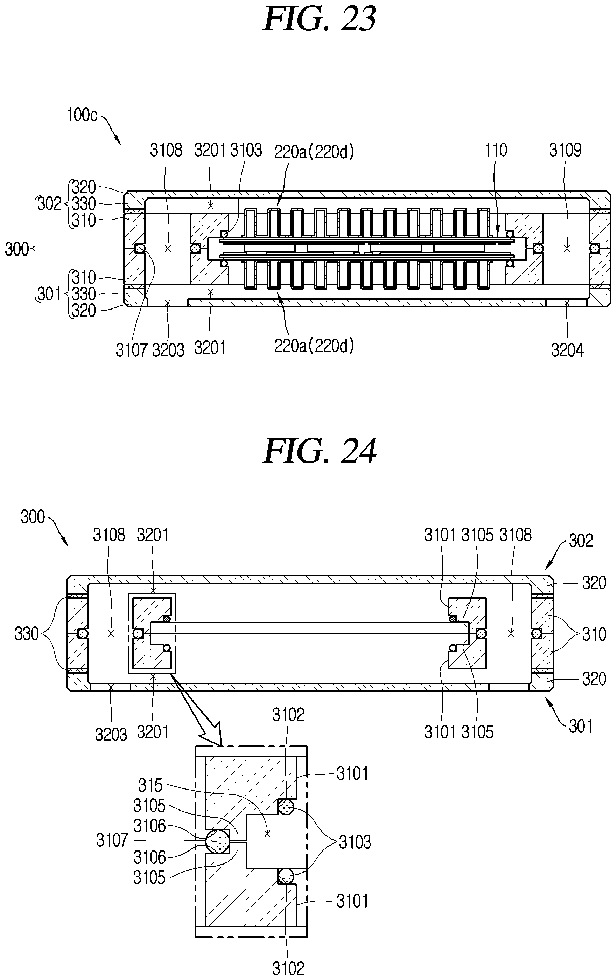

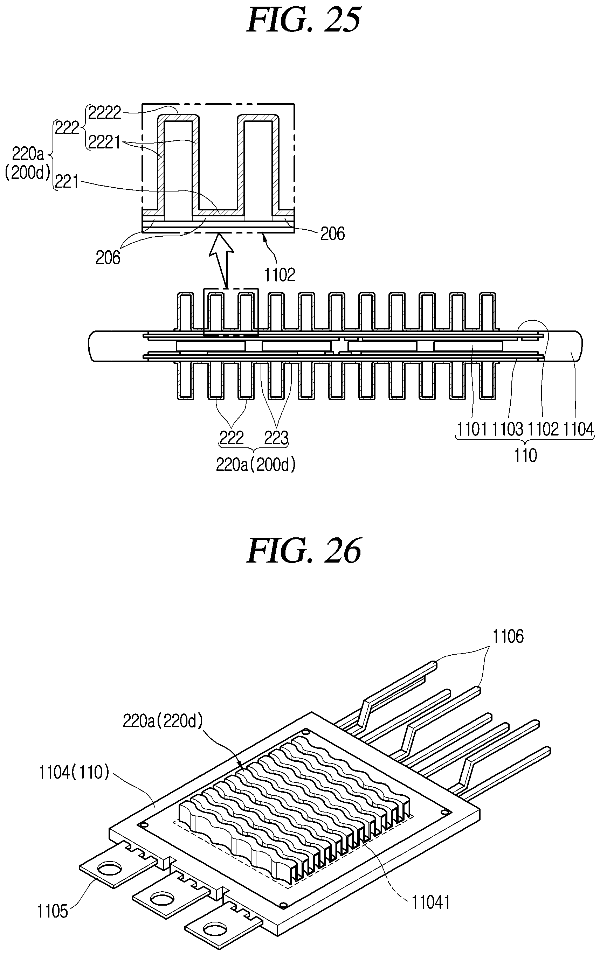

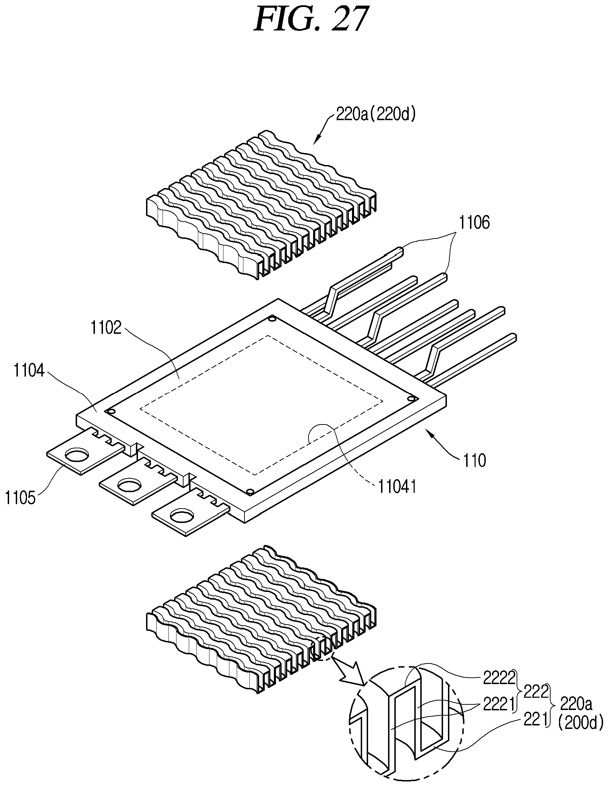

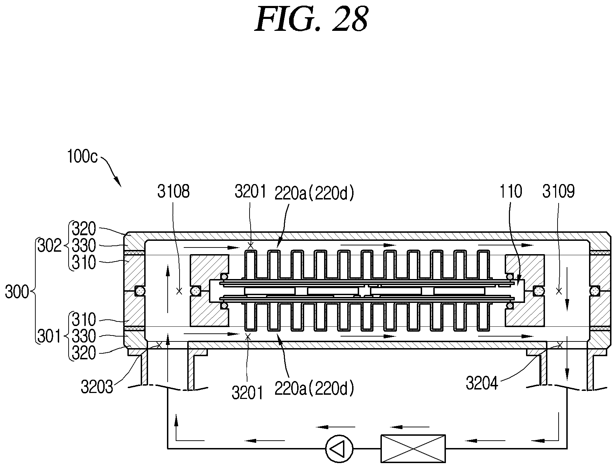

FIG. 23 is a cross-sectional view of a double-side cooling power semiconductor package according to still another embodiment of the present disclosure, FIG. 24 is an enlarged view of lower and upper channels in FIG. 23, FIG. 25 is an enlarged view of a power semiconductor package and a heat sink in FIG. 23, FIG. 26 is a perspective view of a state in which the power semiconductor package and the heat sink of FIG. 24 are coupled to each other, FIG. 27 is an exploded perspective view of a power semiconductor package and a heat sink in FIG. 24, and FIG. 28 is a view for explaining an operation of the double-side cooling power semiconductor package of FIG. 23.

As shown in FIGS. 23 to 25, a double-side cooling power semiconductor package 100c in this embodiment includes a power semiconductor package 110, a heat sink 200d, and plurality of cooling channels 300a.

The power semiconductor package 110 includes, for example, a plurality of circuit elements 1101, an upper substrate 1102 provided on an upper side of the plurality of circuit elements 1101, and a lower substrate 1103 provided on a lower side of the plurality of circuit elements 1101.

The power semiconductor package 110 includes a packaging portion 1104 that wraps (packages) the plurality of circuit elements 1101, the upper substrate 1102, and the lower substrate 1103 into a single body. The packaging portion 1104 is implemented, for example, in a rectangular parallelepiped shape having a relatively thin thickness.

Heat sinks 200d are respectively provided on both sides of the power semiconductor package 110.

The plurality of cooling channels 300a include, for example, a lower channel 301 provided on a lower side of the power semiconductor package 110 and an upper channel 302 provided on an upper side of the power semiconductor package 110.

The plurality of cooling channels 300a each include, for example, a body 31 0 one side of which is in contact with the power semiconductor package 110 along a thickness direction, and a cover 320 coupled to the other side of the body 310 to form the passage 3201 of cooling fluid with respect to the body 310.

A body sealant 330 having a shape corresponding to a shape of the body 310 is provided in a mutual contact region between the body 310 and the cover 320.

Accordingly, cooling fluid may be suppressed from leaking through a gap between the body 310 and the cover 320.

The body 310 of the lower channel 301 and the body 310 of the upper channel 302 are each provided with a through portion 3101 that passes through along a thickness direction to allow the each heat sink 200d to be inserted thereinto.

Around a circumference of each of the through portions 3101, an extension portion 3102 that is recessed with a size that is extended compared to that of the through portion 3101 is provided.

Extension portion sealants 3103 that come into contact with the corresponding power semiconductor packages 110 to suppress the leakage of the cooling fluid are each provided inside the extension portion 3102.

The upper channel 302 and the lower channel 301 are respectively provided with protruding portions 3105 that protrude along a thickness direction to comes into contact with each other.

The protruding portions 3105 are provided at inlet-side and outlet-side end portions of the upper channel 302 and lower channel 301, respectively.

The lower channel 301 is provided with an inlet port 3203 through which cooling fluid flows in and an outlet port 3204 through which cooling fluid flows out.

The inlet port 3203 and outlet port 3204 are each disposed to pass through the cover 320 of the lower channel 301.

An inlet passage 3108 communicating with the inlet port 3203 is disposed on a protruding portion 3105 provided at the inlet-side end portion.

An outlet passage 3109 communicating with the outlet port 3204 is disposed on a protruding portion 3105 provided at the outlet-side end portion.

A mutual contact region between the protruding portions 3105 are each provided with a protruding portion sealant 3107.

Through this, the cooling fluid may be prevented from leaking through the mutual contact region between the protruding portion 3105.

As shown in FIGS. 25 to 27, the power semiconductor package 110 in the present embodiment may be provided with a high temperature region 11041 at the center of which the temperature rises relatively high.

Here, the high temperature region 11041 is disposed by a circuit element 1101 having a relatively large amount of heat generation among the plurality of circuit elements 1101 of the power semiconductor package 110.

In this embodiment, for convenience of explanation of drawings, the high temperature region 11041 is shown as a rectangular shape having a reduced size compared to a rim of the packaging portion 1104, and described as being disposed (formed) at the center of the power semiconductor package 110.

In this embodiment, the heat sink 200d may be configured to be disposed in a high temperature region 11041 of the power semiconductor package 110.

Through this, the heat dissipation in the high temperature region 11041 may be accelerated.

In this embodiment, the heat sink 200d is configured with a waveform heat dissipation fin 220a having a waveform cross-section.

The waveform heat dissipation fins 220a are respectively coupled in direct contact with lower and upper surfaces of the power semiconductor package 110.

The waveform heat dissipation fins 220a are respectively coupled in contact with respective high temperature regions 11041 on the lower and surfaces of the power semiconductor package 110.

The waveform heat dissipation fin 220a is formed of, for example, a metal member.

The waveform heat dissipation fin 220a includes a protruding portion 222 that protrudes from a surface (lower surface, upper surface) of the power semiconductor package 110 and a coupling portion 223 that is coupled in surface contact with a surface of the power semiconductor package 110.

Between the waveform heat dissipation fin 220a and the upper substrate 1102, a bonding portion 206 may be disposed, for example, by metal bonding (see FIG. 25).

The protruding portions 222 and the coupling portion 223 are disposed alternately along a plate surface direction of the power semiconductor package 110.

The waveform heat dissipation fin 220a in this embodiment may suppress an increase in thermal resistance due to the use of the rectangular plate 210 that comes into surface contact with a surface of the power semiconductor package 110.

Through this, the high temperature region 11041 of the power semiconductor package 110 may be cooled more quickly.

The protruding portion 222 is disposed to have a long length along a plate surface direction of the power semiconductor package 110.

The protruding portion 222 is configured with, for example, two side wall portions 2221 spaced apart from each other so as to allow cooling fluid to flow thereinto, and a connecting portion 2222 connecting end portions of the two side wall portions 2221 to each other.

In this embodiment, the protruding portion 222 may be disposed along a movement direction of the cooling fluid.

The protruding portion 222 is configured to have a waveform cross-section along a movement direction of the cooling fluid.

Through this, a contact area between the protruding portion 222 and the cooling fluid may be increased.

In this embodiment, it is illustrated a case where the heat sink 200d is provided with one waveform heat dissipation fin 220a having a size corresponding to the high temperature region 11041, but this is only an example, and the heat sink 200d may be configured to have a plurality of waveform heat dissipation fins 220a.

As shown in FIG. 28, the inlet port 3203 and the outlet port 3204 may be connected to the cooling fluid circulation circuit 400.

The cooling fluid circulation circuit 400 includes a pipe 403 through which the cooling fluid moves.

The cooling fluid circulation circuit 400 includes a heat exchanger 401 in which the cooling fluid is cooled through heat exchange and a pump 402 that accelerates the movement of the cooling fluid.

When an operation is initiated, heat energy is generated by the heat generation of the power semiconductor package 110, and the generated heat energy is transferred to the upper substrate 1102 and the lower substrate 1103, respectively.

When an operation is initiated, the pump 402 is operated, and the cooling fluid is cooled while passing through the heat exchanger 401. The cooled cooling fluid flows into the inlet port 3203 to move along the lower channel 301 and upper channel 302, respectively.

The cooling fluid of the lower channel 301 comes into direct contact with the lower substrate 1103 and the waveform heat dissipation fin 220a to absorb and cool the heat energy of the lower substrate 1103.

The cooling fluid of the upper channel 302 comes into direct contact with the upper substrate 1102 and the waveform heat dissipation fin 220a to absorb and cool heat energy from the upper substrate 1102.

The cooling fluid, whose temperature has increased by absorbing the heat energy, continuously cools the power semiconductor package 110 while repeating a process of cooling while passing through the cooling fluid circulation circuit 400, and absorbing heat energy while passing through the lower channel 301 and the upper channel 302.

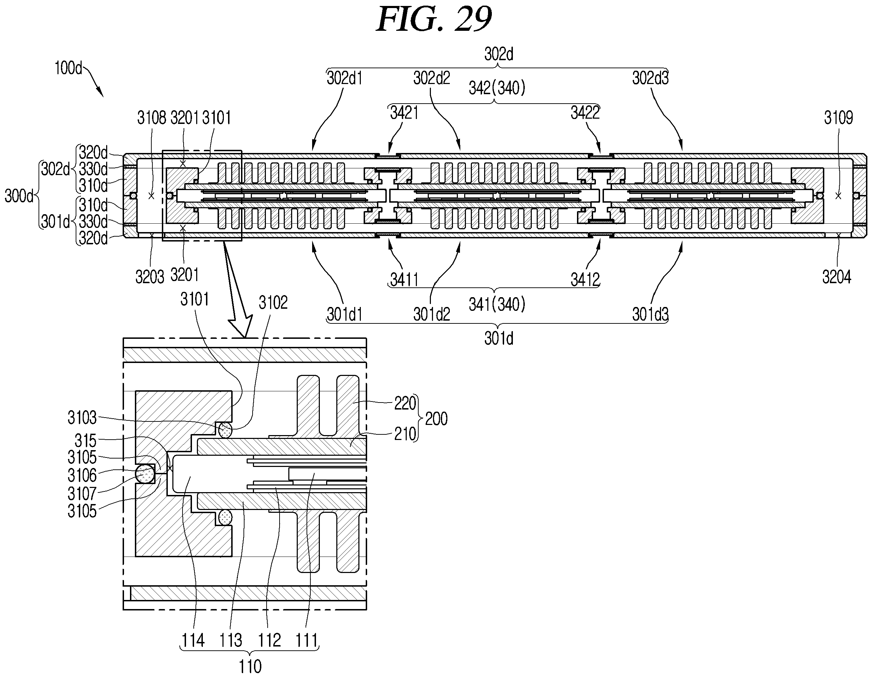

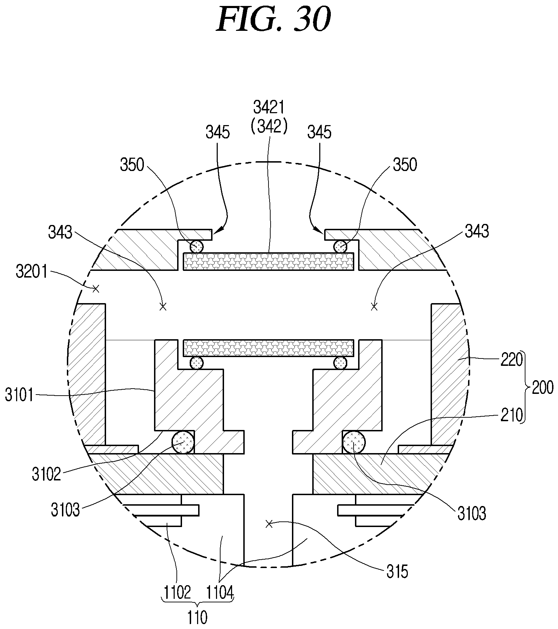

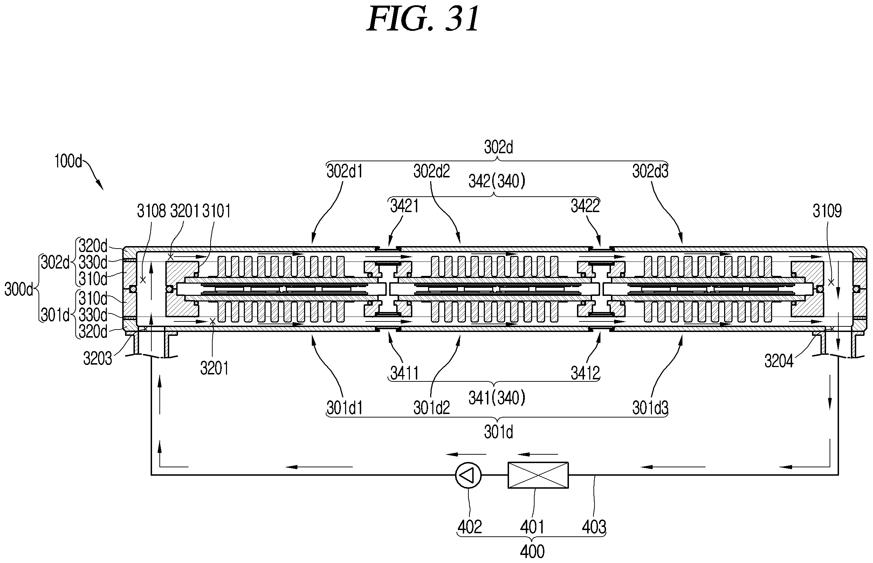

FIG. 29 is a cross-sectional view of a double-side cooling power semiconductor package according to still another embodiment of the present disclosure, FIG. 30 is an enlarged view of a connector and a connector coupling portion region upper cooler in FIG. 29, and FIG. 31 is a view for explaining an operation of the double-side cooling power semiconductor package of FIG. 28. As shown in FIGS. 29 and 30, a double-side cooling power semiconductor package 100d in this embodiment includes a power semiconductor package 110, a heat sink 200, and plurality of cooling channels 300d.

The power semiconductor package 110 includes, for example, a plurality of circuit elements 1101, an upper substrate 1102 provided on an upper side of the plurality of circuit elements 1101, and a lower substrate 1103 provided on a lower side thereof.

The power semiconductor package 110 includes a packaging portion 1104 that wraps (packages) the plurality of circuit elements 1101, the upper substrate 1102, and the lower substrate 1103 into a single body. The packaging portion 1104 is implemented, for example, in a rectangular parallelepiped shape having a relatively thin thickness.

The power semiconductor package 110 is configured with a plurality of units, for example, spaced apart from one another along a plate surface direction.

In this embodiment, the power semiconductor package 110 is configured with, for example, a first power semiconductor package 111, a second power semiconductor package 112, and a third power semiconductor package 113 disposed to be spaced apart from one another along a plate surface direction.

The heat sink 200 is provided on lower and supper surfaces of the first to third power semiconductor packages 111, 112, 113, respectively.

The heat sink 200 includes, for example, a rectangular plate-shaped plate 210 and a plurality of heat dissipation fins 220 protruding from the plate 210 along a thickness direction.

The plate 210 of the heat sink 200 may be bonded to the surface of the power semiconductor package 110. The heat sink 200 may be coupled to a surface of the power semiconductor package 110 by metal bonding (e.g., sintering, soldering or ultrasonic welding).

Meanwhile, in this embodiment, the plurality of cooling channels 300d include, for example, a lower channel 301d provided on a lower side of the power semiconductor package 110 and an upper channel 302d provided on an upper side thereof.

The lower channel 301d includes, for example, a body 310d that comes into contact with a lower side of the of power semiconductor package 110 and a cover 320d coupled to the body 310d to form a passage 3201 of cooling fluid thereinside.

The upper channel 302d includes, for example, a body 310d that comes into contact with an upper side of the of power semiconductor package 110 and a cover 320d coupled to the body 310d to form a passage 3201 of cooling fluid thereinside.

Specifically, for example, the lower channel 301d includes a first lower channel 301d1 provided on a lower side of the first power semiconductor package 111, a second lower channel 301d2 provided on a lower side of the second power semiconductor package 112, and a third lower channel 301d3 provided on a lower side of the third power semiconductor package 113.

The upper channel 302d is configured with, for example, a first upper channel 302d1 provided on an upper side of the first power semiconductor package 111, a second upper channel 302d2 provided on an upper side of the second power semiconductor package 112, and a third upper channel 302d3 provided on an upper side of the third power semiconductor package 113.

Here, each body 310d of the lower channel 301d and each body 310d of the upper channel 302d are each provided with a through portion 3101 that pass therethrough along a thickness direction to allow the each heat sink 200 to be inserted thereinto.

Around a circumference of each of the through portions 3101, an extension portion 3102 that is recessed along a thickness direction to have a size that is extended compared to that of the through portion 3101 is provided.

Extension portion sealants 3103 that come into contact with the respective heat sinks 200 to suppress the leakage of the cooling fluid are each disposed inside the extension portion 3102.

On one side of the lower channel 301, an inlet port 3203 is provided through which the cooling fluid flows in.

The inlet port 3203 is disposed in the first lower channel 301d1.

The inlet port 3203 is disposed to pass through the cover 320d of the first lower channel 301d1 along a thickness direction.

The first lower channel 301d1 and the first upper channel 302d1 are respectively provided with protruding portions 3105 that protrude along a thickness direction to come into contact with each other.

An inlet passage 3108 communicating with the inlet port 3203 is provided inside the protruding portions 3105 of the first lower channel 301d1 and the first upper channel 302d1.

A protruding portion sealant 3107 is provided in a mutual contact region between the protruding portions 3105 of the first lower channel 301d1 and the first upper channel 302d1.

On the other side of the lower channel 301d, an outlet port 3204 through which cooling fluid flows out is provided.

The outlet port 3204 is provided in the third lower channel 301d3.

The outlet port 3204 is disposed to pass through the cover 320d of the third lower channel 301d3 in a thickness direction.

The third lower channel 301d3 and the third upper channel 302d3 are respectively provided with protruding portions 3105 that protrude along a thickness direction to come into contact with each other.

An outlet passage 3109 communicating with the outlet port 3204 is provided inside the protruding portions 3105 of the third lower channel 301d3 and the third upper channel 302d3.

A protruding portion sealant 3107 is provided in a mutual contact region between the protruding portions 3105 of the third lower channel 301d3 and the third upper channel 302d3.

Meanwhile, the lower channel 301d and the upper channel 302d spaced apart from each other along a plate surface direction are connected in communication with each other by a connector 340 disposed along a plate surface direction.

The connector 340 includes a lower connector 341 that connects the lower channels 301d and an upper connector 342 that connects the upper channels 302d.

Specifically, the lower connector 341 includes a first lower connector 3411 connecting the first lower channel 301d1 and the second lower channel 301d2, and a second lower connector 3412 connecting the second lower channel 301d2 and the third lower channel 301d3.

The upper connector 342 includes a first upper connector 3421 connecting the first upper channel 302d1 and the second upper channel 302d2 and a second upper connector 3422 connecting the second upper channel 302d2 and the third upper channel 302d3.

The structures of the respective connectors 340 are the same, the first upper connector 3421 will be described below as an example.

A connector coupling portion 345 is disposed in each of the first upper channel 302d1 and the second upper channel 302d2 adjacent to each other to allow each end portion of the first upper connector 3421 to be coupled thereto.

Each of the connector coupling portions 345 is disposed to be recessed inward to allow an end portion of the first upper connector 3421 to be inserted into and coupled thereto at a preset depth.

Here, the connector 340 may be implemented in a pipe shape.

The connector coupling portions 345 of the first upper channel 302d1 and the second upper channel 302d2 are configured to have an inner width (inner diameter) that is extended compared to an outer width (outer diameter) of the connector 340.

A communication portion 343 communicating with a passage 3201 inside the each upper channel 302d is disposed on one inner side of the connector coupling portion 345.

The first upper connector 3421 (connector 340) communicates with the passages 3201 of the first upper channel 302d1 and the second upper channel 302d2 through the communication portion 343.

Connector sealants 350 are respectively provided between the connector 340 and the connector coupling portion 345.

The connector sealant 350 may be formed of, for example, an elastic sealing member (e.g., a rubber member, a silicone member).

Accordingly, when thermal deformation occurs along a plate surface direction of the each power semiconductor package 110, the deformation may be absorbed by the slip of the connector 340, the connector coupling portion 345, and the connector sealant 350.

As shown in FIG. 31, the double-side cooling power semiconductor package 110d in this embodiment may be connected to a cooling fluid circulation circuit 400.

The cooling fluid circulation circuit 400 includes a pipe 403 through which the cooling fluid moves.

The cooling fluid circulation circuit 400 includes a heat exchanger 401 in which the cooling fluid is cooled through heat exchange and a pump 402 that accelerates the movement of the cooling fluid.

When an operation is initiated, heat energy is generated by the heat generation of the respective circuit elements 1101 in the first power semiconductor package 111, the second power semiconductor package 112, and the third power semiconductor package 113.

The heat energy generated from each of the circuit elements 1101 is transferred to the heat sinks 200 on both sides thereof along a thickness direction.

When an operation is initiated, the pump 402 is operated, and the cooling fluid is cooled while passing through the heat exchanger 401. The cooled cooling fluid flows into the inlet port 3203, and part of the cooling fluid that has flowed in absorbs heat energy while passing through the first lower channel 301d1. The cooling fluid passing through the first lower channel 301 d1 absorbs heat energy to increase in temperature while passing through the first lower channel 3411, the second lower channel 301d2, the second lower channel 3412, and the third lower channel 301d3.

In addition, another part of the cooling fluid flowing into the inlet port 3203 absorbs heat energy to increase in temperature while passing through the inlet passage 3108, the first upper channel 302d1, the first upper connector 3421, the second upper channel 302d2, the second upper connector 3422, and the third upper channel 302d3.

The cooling fluid passing through the third upper channel 302d3 moves along the outlet passage 3109 and joins with the cooling fluid passing through the third lower channel 301d3 to flow out through the outlet port 3204.

The cooling fluid flowing out of the outlet port 3204 cools the each power semiconductor package 110 while repeating a process of cooling in the heat exchanger 401 while circulating along the cooling fluid circulation circuit 400, and flowing into the inlet port 3203, to absorb heat energy while passing through the lower channel 301d and the upper channel 302d.

In the above, specific embodiments of the present disclosure have been shown and described. However, the present disclosure may be implemented in various forms without departing from the concept or gist thereof, and thus the embodiments described above should not be limited to specific contents for carrying out the disclosure.

Furthermore, the foregoing embodiments should be broadly construed within the scope of the technical concept defined by the appended claims even though they are not specifically disclosed in the detailed description herein. Moreover, all changes and modifications within the technical scope of the claims and the equivalent scope thereof should be construed to be included in the appended claims.

## Claims

1. A double-side cooling power semiconductor package comprising:
a plate-shaped power semiconductor package;
heat sinks disposed along a thickness direction of the power semiconductor package on both sides thereof; and
a plurality of cooling channels provided with a passage of cooling fluid thereinside, and provided along the thickness direction of the power semiconductor package on both sides thereof,
wherein through portions to allow one region of the heat sink to be inserted thereinto are respectively provided in the plurality of cooling channels.

2. The double-side cooling power semiconductor package of claim 1, wherein the plurality of cooling channels each comprise:
a body one side of which is in contact with the power semiconductor package along a thickness direction; and
a cover coupled to the other side of the body to form the passage of cooling fluid with respect to the body,
wherein the through portion is disposed to pass through the body along the thickness direction.

3. The double-side cooling power semiconductor package of claim 2, wherein a body sealant corresponding to a rim shape of the body is provided in a mutual contact region between the body and the cover.

4. The double-side cooling power semiconductor package of claim 3, wherein a body sealant receiving portion is disposed in the body so as to receive the body sealant.

5. The double-side cooling power semiconductor package of claim 2, wherein the cooling channel comprises:
a lower channel provided on a lower side of the power semiconductor package; and
an upper channel provided on an upper side of the power semiconductor package.

6. The double-side cooling power semiconductor package of claim 5, wherein the lower channel and the upper channel are connected in parallel to a cooling fluid circulation circuit in which the cooling fluid is circulated.

7. The double-side cooling power semiconductor package of claim 6, wherein the lower channel comprises:
an inlet port through which the cooling fluid flows in; and
an outlet port through which the cooling fluid flows out,
wherein the inlet port and the outlet port are each connected to the cooling fluid circulation circuit.

8. The double-side cooling power semiconductor package of claim 5, wherein the body is provided with an extension portion that is recessed in a thickness direction so as to have a size that is extended compared to that of the through portion around the through portion, and
wherein an extension portion sealant is provided inside the extension portion to come into contact with the heat sink so as to suppress the leakage of the cooling fluid.

9. The double-side cooling power semiconductor package of claim 8, wherein the heat sink comprises:
a plate that comes into contact with the power semiconductor package with a size that is extended compared to that of the extension portion; and
a plurality of heat dissipation fins protruding in a thickness direction from the plate.

10. The double-side cooling power semiconductor package of claim 7, wherein the heat sink comprises a waveform heat dissipation fin having a waveform cross-section, and
wherein the waveform heat dissipation fin is coupled to a surface of the power semiconductor package.

11. The double-side cooling power semiconductor package of claim 7, wherein the inlet and outlet ports are respectively disposed in the cover, and
wherein a body of the lower channel and a body of the upper channel are each provided with an inlet passage communicating with the inlet port and an outlet passage communicating with the outlet port.

12. The double-side cooling power semiconductor package of claim 11, wherein inlet-side and outlet-side end portions of the lower channel and the upper channel are each provided with protruding portions that protrude along a thickness direction to come into contact with each other,
wherein a power semiconductor package insertion space is formed into which the power semiconductor package is inserted between the protruding portions, and
wherein the inlet and outlet passages are respectively disposed inside the protruding portions.

13. The double-side cooling power semiconductor package of claim 12, wherein a protruding portion sealant is provided in a mutual contact region between the protruding portions to suppress the leakage of the cooling fluid.

14. The double-side cooling power semiconductor package of claim 5, wherein the power semiconductor package is configured with a plurality of units spaced apart from one another along a plate surface direction, and
wherein the body is provided with a plurality of through portions spaced apart from one another along a plate surface direction to allow the heat sinks of the plurality of power semiconductor packages to be inserted thereinto, respectively.

15. The double-side cooling power semiconductor package of claim 2, wherein the power semiconductor package is configured with a plurality of units spaced apart from one another along a thickness direction,
wherein the cooling channel comprises:
a lower channel disposed at a lowermost side of the power semiconductor package configured with the plurality of units;
an upper channel disposed at an uppermost side of the power semiconductor package configured with the plurality of units; and
an intermediate channel disposed between the power semiconductor packages configured with the plurality of units, and
wherein the lower channel, the upper channel, and the intermediate channel are each disposed such that inlet and outlet sides of the cooling fluid are connected in communication with one another.

16. The double-side cooling power semiconductor package of claim 15, wherein the lower channel comprises a lower body disposed at a lowermost side of the power semiconductor package configured with the plurality of units and disposed to have the through portion; and a lower cover coupled to a bottom portion of the lower body to form the passage of cooling fluid thereinside,
wherein the upper channel comprises an upper body disposed at an uppermost side of the power semiconductor package configured with the plurality of units and disposed to have the through portion; and an upper cover coupled to an upper surface of the upper body to form the passage of cooling fluid thereinside, and
wherein the intermediate channel comprises an upper body disposed on an upper side of the power semiconductor package configured with the plurality of units and provided with the through portion; a lower body disposed to be spaced apart from an upper side of the upper body, coupled to a lower surface of the power semiconductor package configured with the plurality of units, and provided with the through portion; and an intermediate cover disposed between the upper body and the lower body to partition an inside of the upper body and an inside of the lower body.

17. The double-side cooling power semiconductor package of claim 16, wherein the lower cover is provided with an inlet port through which the cooling fluid flows in and an outlet port through which the cooling fluid flows out, and
wherein the lower body and the upper body are provided with an inlet passage communicating with the inlet port and an outlet passage communicating with the outlet port.

18. The double-side cooling power semiconductor package of claim 5, wherein the power semiconductor package is configured with a plurality of units spaced apart from one another along a plate surface direction,
wherein the power semiconductor package configured with the plurality of units is each provided with the lower channel and the upper channel, and
wherein the lower channel and the upper channel spaced apart from each other along the plate surface direction are respectively connected in communication with each other by a connector disposed along the plate surface direction.

19. The double-side cooling power semiconductor package of claim 18, wherein the upper channel and lower channel of the power semiconductor package configured with the plurality of units are each provided with a connector coupling portion to which the connector is coupled, and
wherein a connector sealant is provided in a mutual contact region between the each connector coupling portion and the each connector.
